# EUROPEAN PATENT APPLICATION

(11) **EP 4 693 403 A1**
(43) Date of publication of application: **11.02.2026**
(21) Application number: 23930795.2
(22) Date of filing: 30.10.2023
(51) Int. Cl.: H01L 27/146

(54) **LIGHT DETECTION DEVICE AND ELECTRONIC APPARATUS**

(30) Priority: 27.03.2023 JP 2023050034
(71) Applicant: Sony Semiconductor Solutions Corporation, Atsugi-shi, Kanagawa 243-0014 (JP)
(72) Inventor: EBIHARA Yasuhiro, Atsugi-shi, Kanagawa 243-0014 (JP); FUJIMOTO Shogo, Kikuchi-gun, Kumamoto 869-1102 (JP); MATSUMOTO Akira, Atsugi-shi, Kanagawa 243-0014 (JP)
(74) Representative: Müller Hoffmann & Partner
(86) International application number: PCT/JP2023/039146
(87) International publication number: WO 2024/202166

(57) **Abstract**

Provided is a light detection device that enables a connecting portion for connecting a light shielding film to a ground potential to have a more appropriate configuration. A configuration including a semiconductor substrate, a plurality of photoelectric conversion units that are formed in a two-dimensional array on a semiconductor substrate, a trench portion that is formed in a region between the photoelectric conversion units in the semiconductor substrate, and a hole accumulation region that is formed on an inner wall surface of the trench portion, holes being accumulated in the hole accumulation region, and a light shielding film that is disposed on a side of a rear surface of the semiconductor substrate and shields light in a region between the photoelectric conversion units in an effective pixel region in the semiconductor substrate and a light shielding pixel region located around the effective pixel region as a whole is adopted. Also, the hole accumulation region is continuously formed from the rear surface to a front surface of the semiconductor substrate. Furthermore, a connecting portion that causes the light shielding film to be electrically connected to the hole accumulation region is formed between a rear surface of the light shielding pixel region and the light shielding film.

## Description

### [Technical Field]

The present technology (the technology according to the present disclosure) relates to a light detection device and an electronic device.

### [Background Art]

Conventionally, a light detection device including a semiconductor substrate that includes a plurality of photoelectric conversion units and a light shielding film that is disposed on a side of a light receiving surface of the semiconductor substrate, shields light in a region between the photoelectric conversion units located in an effective pixel region, and shields light in an entire peripheral region (including a light shielding pixel region and a region on a side further outward than the light shielding pixel region) of the semiconductor substrate, for example, has been proposed (see PTL 1, for example). The light detection device described in PTL 1 is configured such that a p-type impurity layer (hereinafter, also referred to as a "p-well region") in the entire thickness direction of the semiconductor substrate is formed in the region on the side further outward than the light shielding pixel region, the formed p-well region is electrically connected to a ground potential, and a contact that electrically connects the p-well region to the light shielding film is further formed. It is thus possible to electrically connect the light shielding film to a ground potential via the contact and the p-well region, and abnormal discharge called arcing is prevented from occurring in the light shielding film in a manufacturing process, for example. Also, breakage of the light shielding film and defects (film thickness unevenness, cracking, pinholes) in film formation due to charged dust collection are prevented, and image quality is improved.

### [Citation List]

### [Patent Literature]

[PTL 1]
JP 2022-51782A

### [Summary]

### [Technical Problem]

Such a light detection device is required to have a contact (a "connecting portion" in a broad sense) with a more appropriate configuration.

An object of the present disclosure is to provide a light detection device and an electronic device that enable a connecting portion for connecting the light shielding film to a ground potential to have a more appropriate configuration.

### [Solution to Problem]

According to a gist of the present disclosure, a light detection device includes (a) a semiconductor substrate, (b) a plurality of photoelectric conversion units that are formed in a two-dimensional array in the semiconductor substrate, (c) a trench portion that is formed in a region between the photoelectric conversion units in the semiconductor substrate, (d) a hole accumulation region that is formed on an inner wall surface of the trench portion, holes being accumulated in the hole accumulation region, and (e) a light shielding film that is formed on a side of a first surface that is a light receiving surface of the semiconductor substrate and shields light in a region between the photoelectric conversion units in an effective pixel region in the semiconductor substrate and a light shielding pixel region located around the effective pixel region as a whole, in which (f) the hole accumulation region is continuously formed from the first surface to a second surface, which is a surface on a side opposite to the first surface, of the semiconductor substrate, and (g) the light detection device further includes a connecting portion that is formed between the first surface of the light shielding pixel region and the light shielding film and causes the light shielding film to be electrically connected to the hole accumulation region.

According to another gist of the present disclosure, a light detection device includes (a) a semiconductor substrate, (b) a plurality of photoelectric conversion units that are formed in a two-dimensional array in the semiconductor substrate, (c) a trench portion that is formed in a region between the photoelectric conversion units in the semiconductor substrate, (d) a conductor that is embedded in the trench portion, and (e) a light shielding film that is disposed on a side of a first surface that is a light receiving surface of the semiconductor substrate and shields light in a region between the photoelectric conversion units in an effective pixel region in the semiconductor substrate and a light shielding pixel region located around the effective pixel region as a whole, in which (f) the conductor is continuously formed from the first surface to a second surface, which is a surface on a side opposite to the first surface, of the semiconductor substrate, and (g) the light detection device further includes a connecting portion that is formed between the first surface of the light shielding pixel region and the light shielding film and causes the light shielding film to be electrically connected to the conductor.

According to another gist of the present disclosure, a light detection device includes (a) a semiconductor substrate, (b) a plurality of photoelectric conversion units that are formed in a two-dimensional array in the semiconductor substrate, (c) a light shielding film that is disposed on a side of a first surface that is a light receiving surface of the semiconductor substrate and shields light in a region between the photoelectric conversion units in an effective pixel region in the semiconductor substrate and a peripheral region surrounding the effective pixel region, (d) a hydrogen barrier film that is formed between the semiconductor substrate and the light shielding film and inhibits passage of hydrogen, and (e) a connecting portion that is formed between the first surface of the peripheral region and the light shielding film, penetrates through the hydrogen barrier film, and causes the light shielding film to be electrically connected to a ground region of the semiconductor substrate, in which (f) in a view in a thickness direction of the semiconductor substrate, a range that the connecting portion occupies in a circumferential direction surrounding the effective pixel region is a part of an entire periphery in the circumferential direction.

According to a gist of the present disclosure, an electronic device includes a light detection device including (a) a semiconductor substrate, (b) a plurality of photoelectric conversion units that are formed in a two-dimensional array in the semiconductor substrate, (c) a trench portion that is formed in a region between the photoelectric conversion units in the semiconductor substrate, (d) a hole accumulation region that is formed on an inner wall surface of the trench portion, holes being accumulated in the hole accumulation region, and (e) a light shielding film that is disposed on a side of a first surface that is a light receiving surface of the semiconductor substrate and shields light in a region between the photoelectric conversion units in an effective pixel region in the semiconductor substrate and a light shielding pixel region located around the effective pixel region as a whole, in which (f) the hole accumulation region is continuously formed from the first surface to a second surface, which is a surface on a side opposite to the first surface, of the semiconductor substrate, and (g) the light detection device further includes a connecting portion that is formed between the first surface of the light shielding pixel region and the light shielding film and causes the light shielding film to be electrically connected to the hole accumulation region.

According to another gist of the present disclosure, an electronic device includes a light detection device including (a) a semiconductor substrate, (b) a plurality of photoelectric conversion units that are formed in a two-dimensional array on a semiconductor substrate, (c) a trench portion that is formed in a region between the photoelectric conversion units in the semiconductor substrate, (d) a conductor that is embedded in the trench portion, and (e) a light shielding film that is disposed on a side of a first surface that is a light receiving surface of the semiconductor substrate and shields light in a region between the photoelectric conversion units in an effective pixel region in the semiconductor substrate and a light shielding pixel region located around the effective pixel region as a whole, in which (f) the conductor is continuously formed from the first surface to a second surface, which is a surface on a side opposite to the first surface, of the semiconductor substrate, and (g) the light detection device further includes a connecting portion that is formed between the first surface of the light shielding pixel region and the light shielding film and causes the light shielding film to be electrically connected to the conductor.

According to another gist of the present disclosure, an electronic device includes a light detection device including (a) a semiconductor substrate, (b) a plurality of photoelectric conversion units that are formed in a two-dimensional array in the semiconductor substrate, (c) a light shielding film that is disposed on a side of a first surface that is a light receiving surface of the semiconductor substrate and shields light in a region between the photoelectric conversion units in an effective pixel region in the semiconductor substrate and a peripheral region surrounding the effective pixel region, (d) a hydrogen barrier film that is formed between the semiconductor substrate and the light shielding film and inhibits passage of hydrogen, and (e) a connecting portion that is formed between the first surface of the peripheral region and the light shielding film, penetrates through the hydrogen barrier film, and causes the light shielding film to be electrically connected to a ground region of the semiconductor substrate, in which (f) in a view in a thickness direction of the semiconductor substrate, a range that the connecting portion occupies in a circumferential direction surrounding the effective pixel region is a part of an entire periphery in the circumferential direction.

### [Brief Description of Drawings]

[Fig. 1]

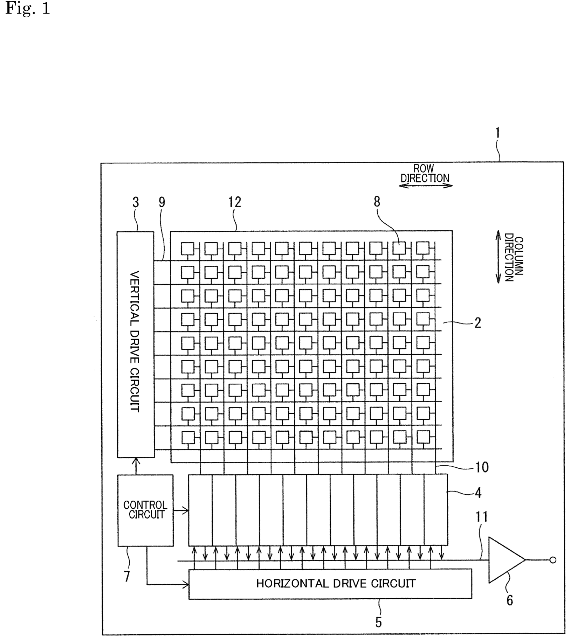

   Fig. 1 is a diagram illustrating an overall configuration of a solid-state imaging device according to a first embodiment.
[Fig. 2]

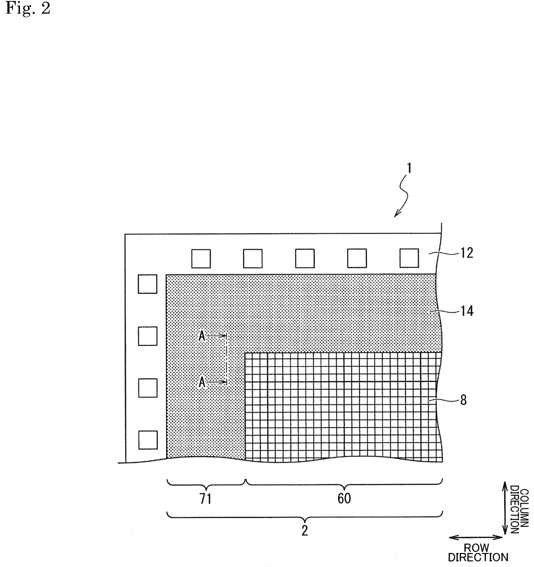

   Fig. 2 is a diagram illustrating a planar configuration at one of four corners of a pixel region.
[Fig. 3]

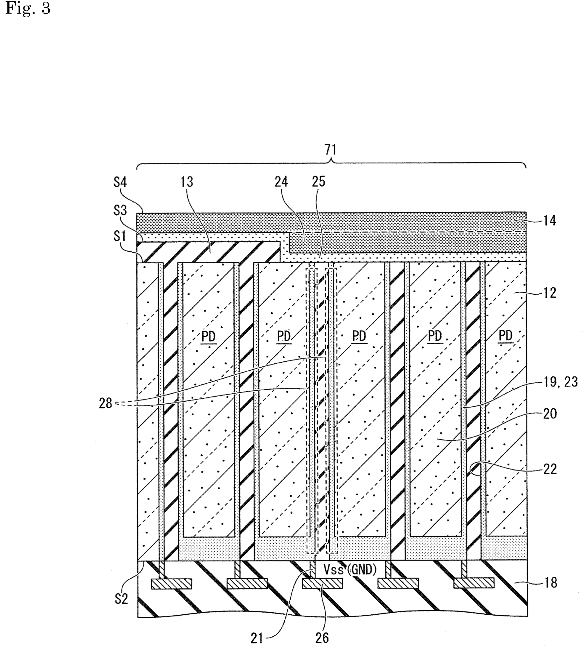

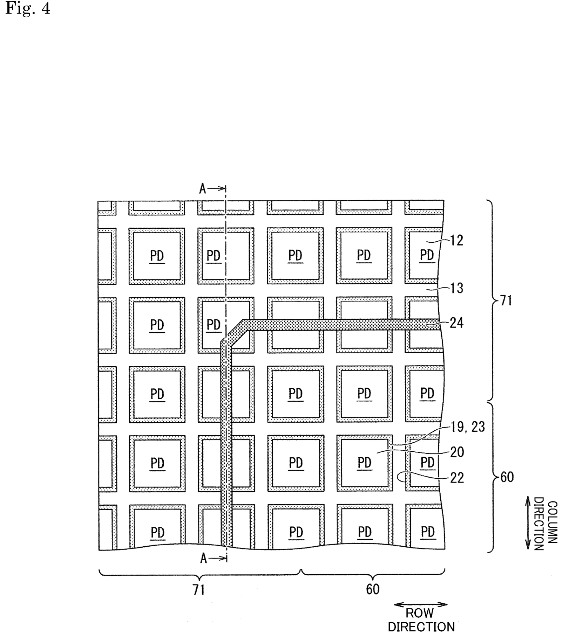

   Fig. 3 is a diagram illustrating a sectional configuration of the solid-state imaging device taken along the line A-A in Figs. 2 and 4.
[Fig. 4]
   Fig. 4 is a diagram illustrating a positional relationship in a planar configuration between a semiconductor substrate and a contact in a view in a thickness direction of the semiconductor substrate.
[Fig. 5]

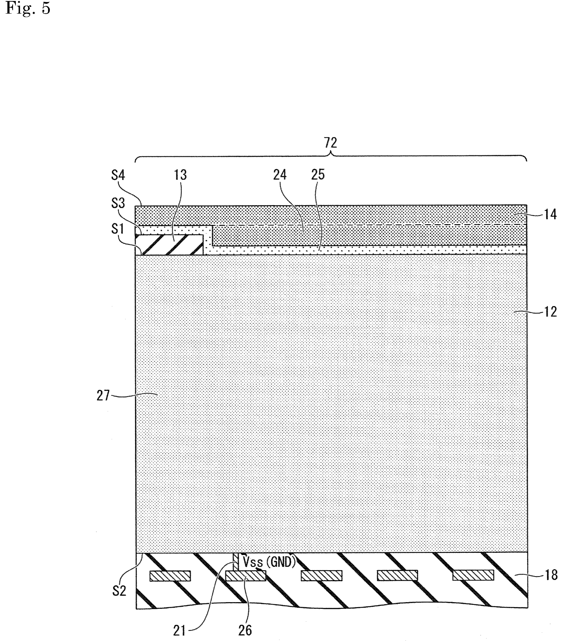

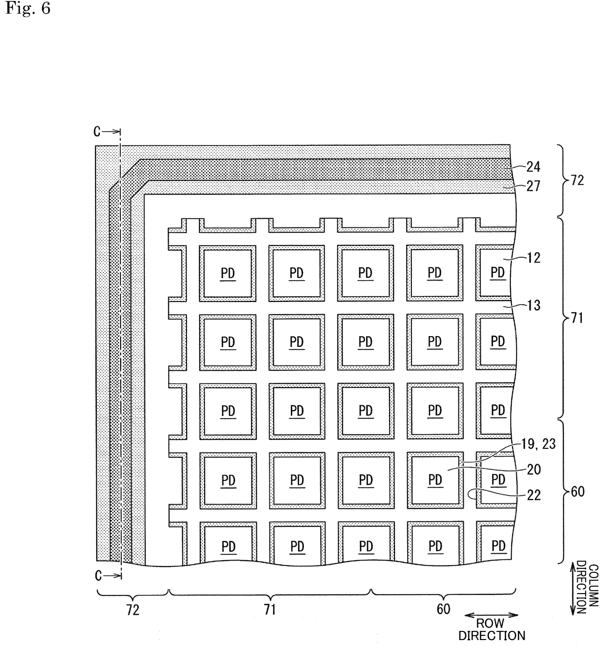

   Fig. 5 is a diagram illustrating a sectional configuration of a solid-state imaging device according to a comparative example taken along the line C-C in Fig. 6.
[Fig. 6]
   Fig. 6 is a diagram illustrating a positional relationship in a planar configuration between a semiconductor substrate and a contact in a view in a thickness direction of a semiconductor substrate.
[Fig. 7]

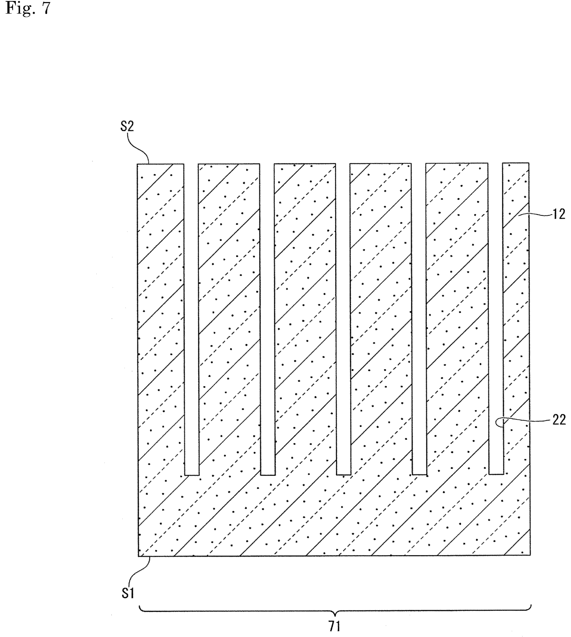

   Fig. 7 is a diagram illustrating a method of manufacturing a solid-state imaging device.
[Fig. 8]

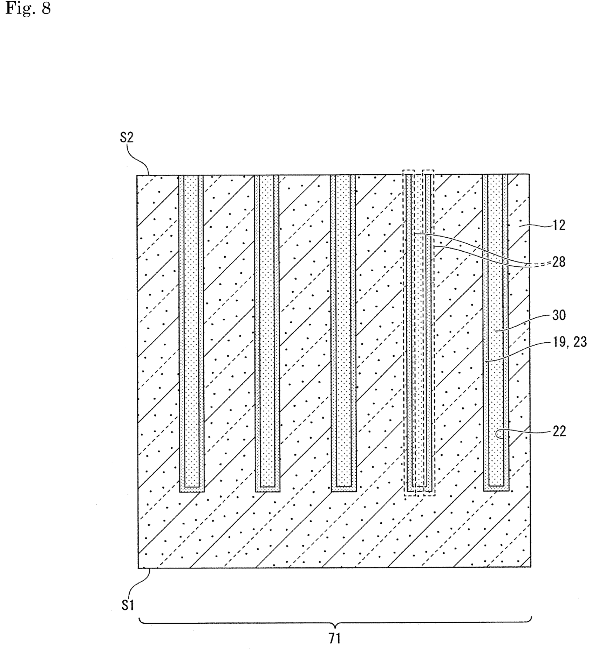

   Fig. 8 is a diagram illustrating the method of manufacturing a solid-state imaging device.
[Fig. 9]

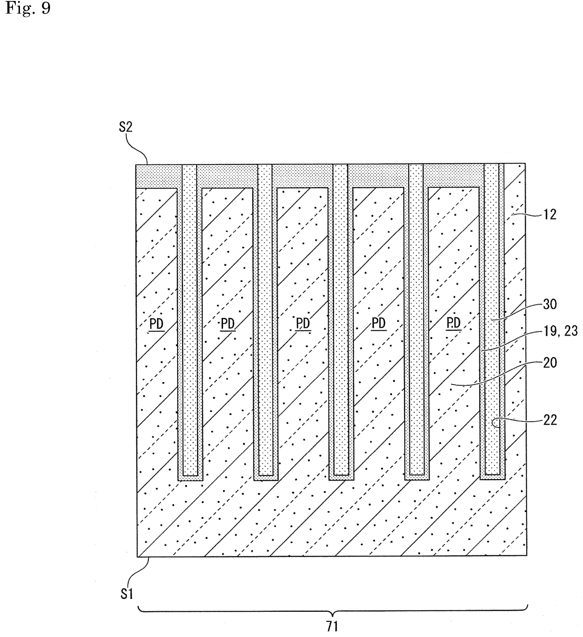

   Fig. 9 is a diagram illustrating the method of manufacturing a solid-state imaging device.
[Fig. 10]

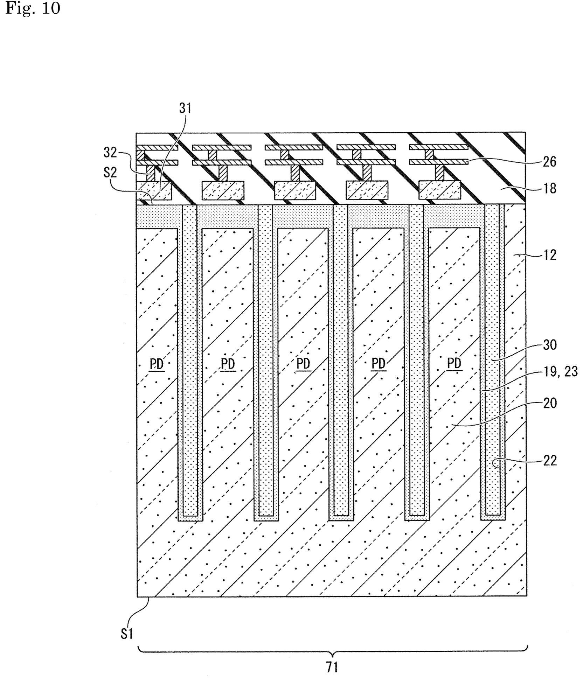

   Fig. 10 is a diagram illustrating the method of manufacturing a solid-state imaging device.
[Fig. 11]

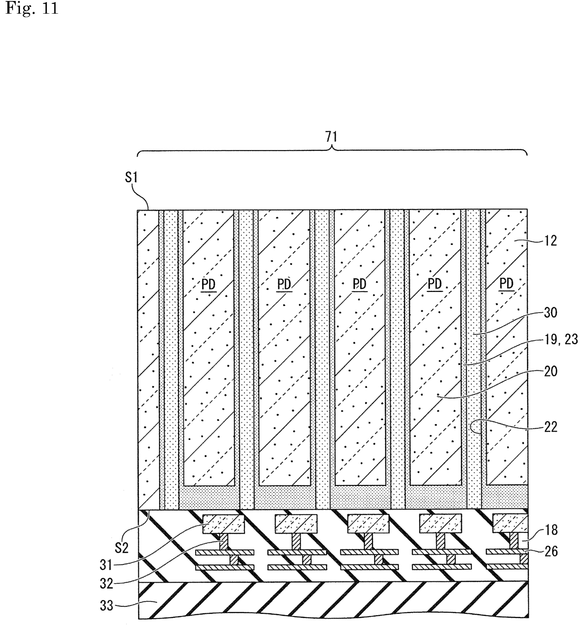

   Fig. 11 is a diagram illustrating the method of manufacturing a solid-state imaging device.
[Fig. 12]

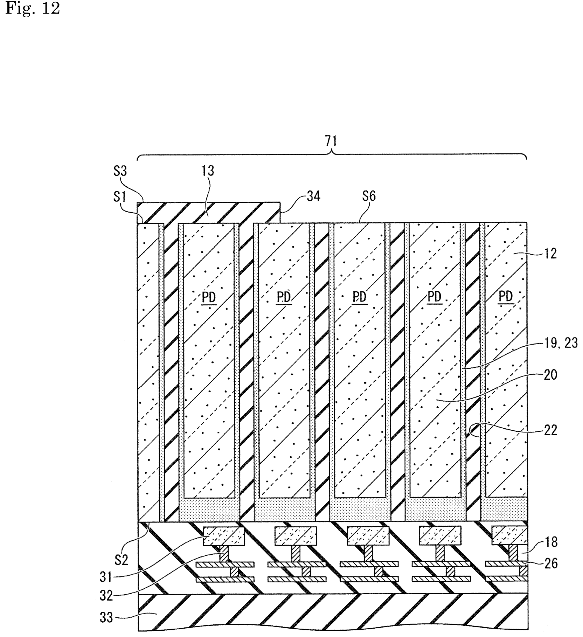

   Fig. 12 is a diagram illustrating the method of manufacturing a solid-state imaging device.
[Fig. 13]

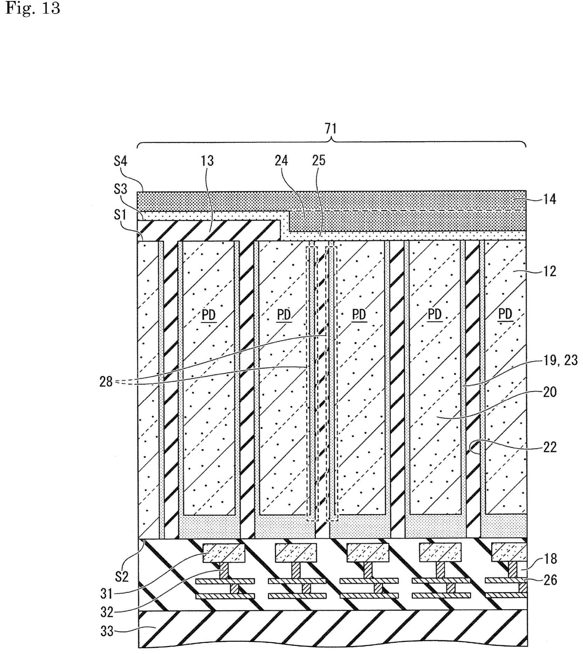

   Fig. 13 is a diagram illustrating the method of manufacturing a solid-state imaging device.
[Fig. 14]

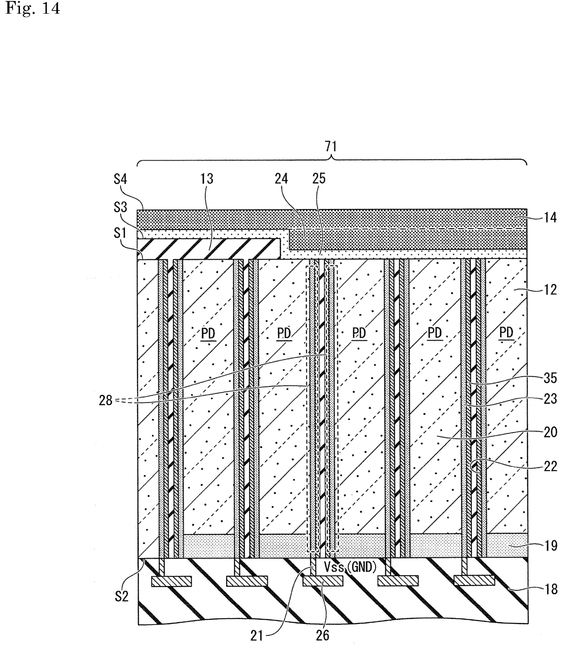

   Fig. 14 is a diagram illustrating a sectional configuration of a solid-state imaging device according to a modification example (1).
[Fig. 15]

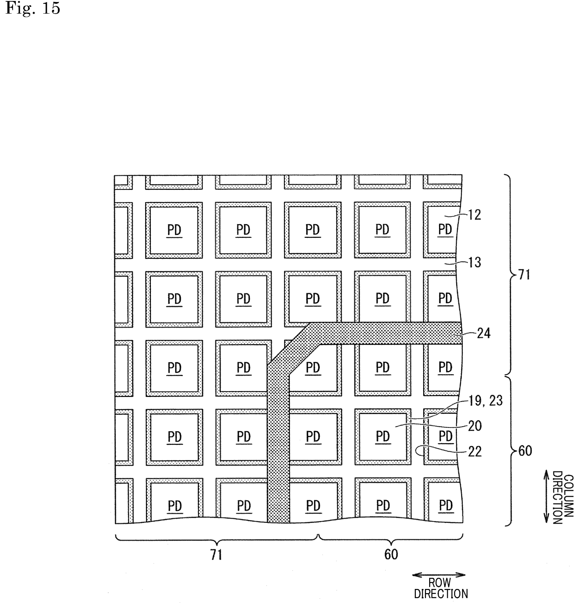

   Fig. 15 is a diagram illustrating a planar configuration of a connecting portion in a modification example (2).
[Fig. 16]

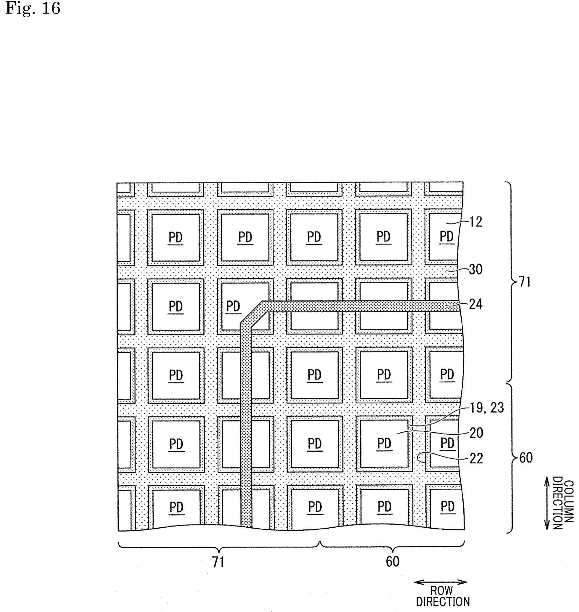

   Fig. 16 is a diagram illustrating a planar configuration of a connecting portion in a modification example (3).
[Fig. 17]

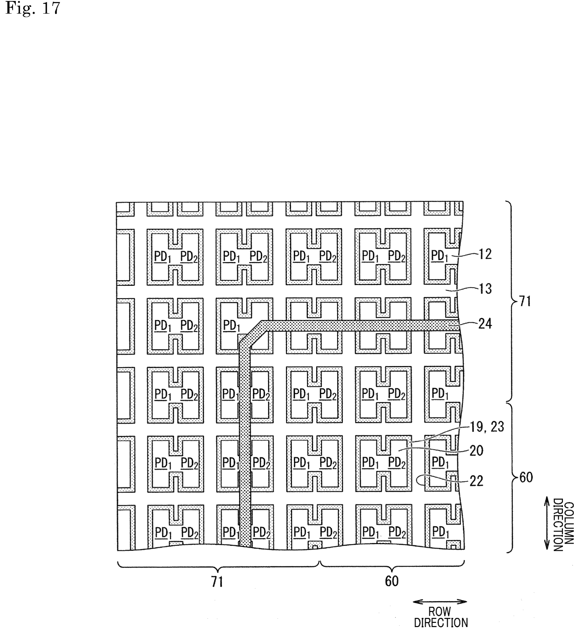

   Fig. 17 is a diagram illustrating a planar configuration of a connecting portion in a modification example (4).
[Fig. 18]

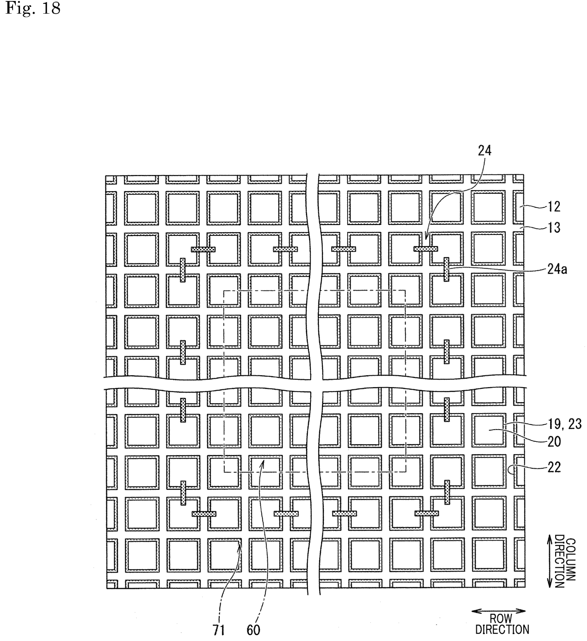

   Fig. 18 is a diagram illustrating a planar configuration of a connecting portion in a modification example (5).
[Fig. 19]

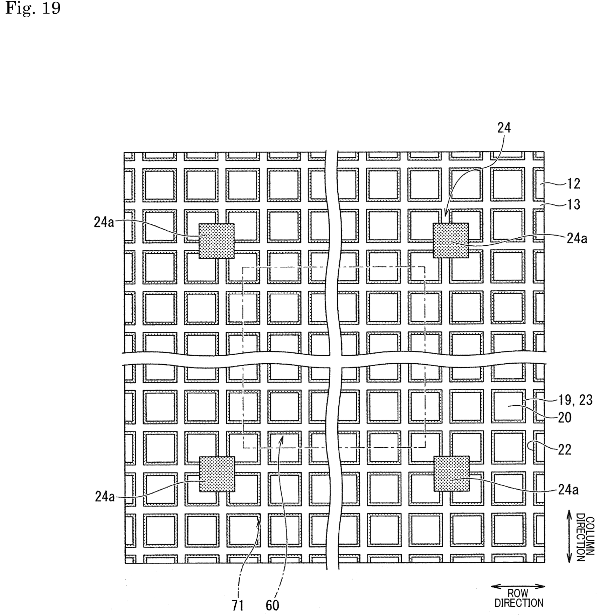

   Fig. 19 is a diagram illustrating the planar configuration of the connecting portion in the modification example (5).
[Fig. 20]

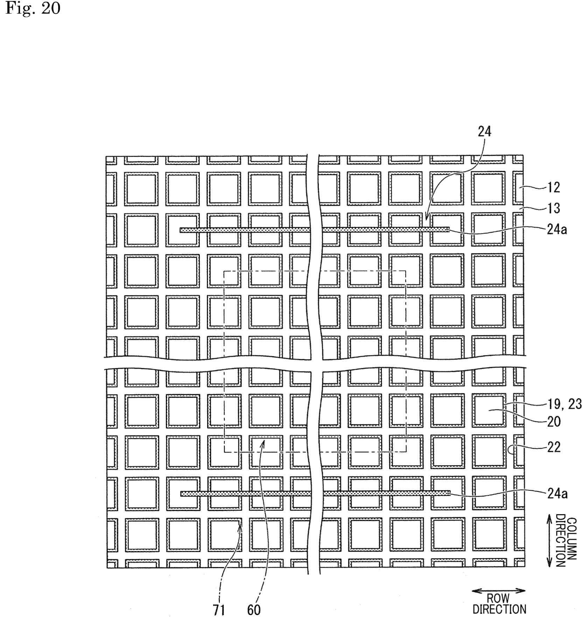

   Fig. 20 is a diagram illustrating a planar configuration of a connecting portion in a modification example (6).
[Fig. 21]

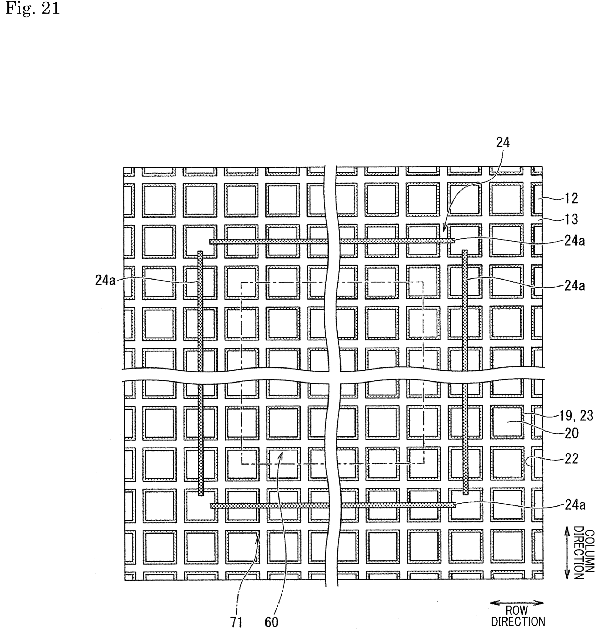

   Fig. 21 is a diagram illustrating the planar configuration of the connecting portion in the modification example (6).
[Fig. 22]

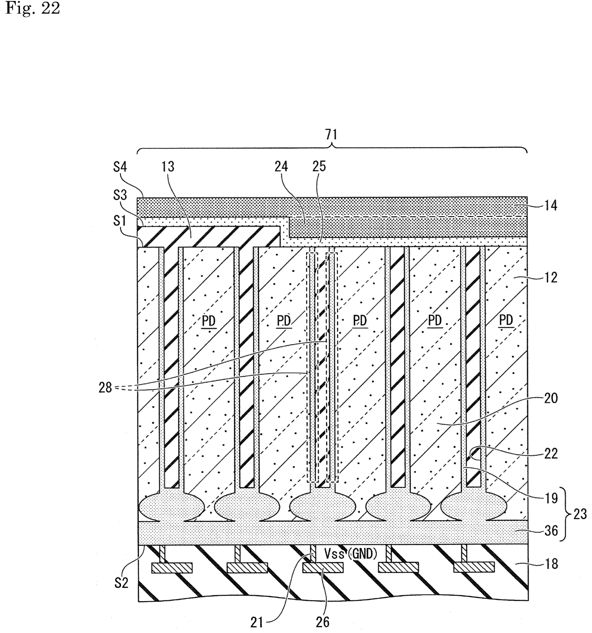

   Fig. 22 is a diagram illustrating a sectional configuration of a solid-state imaging device according to a modification example (7).
[Fig. 23]

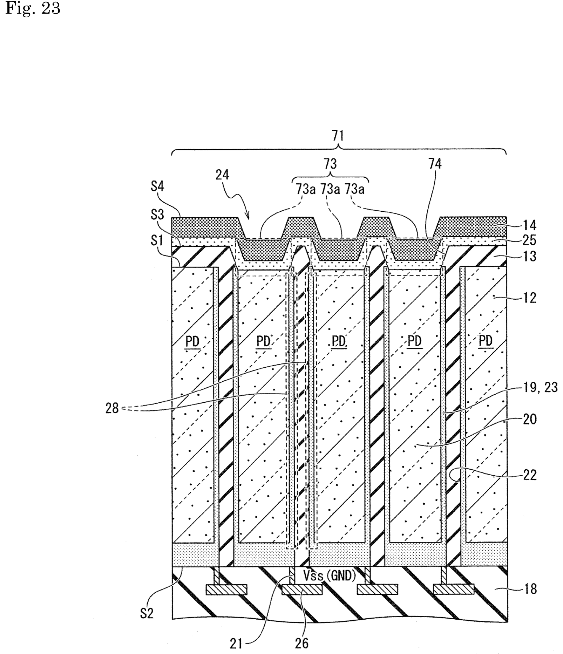

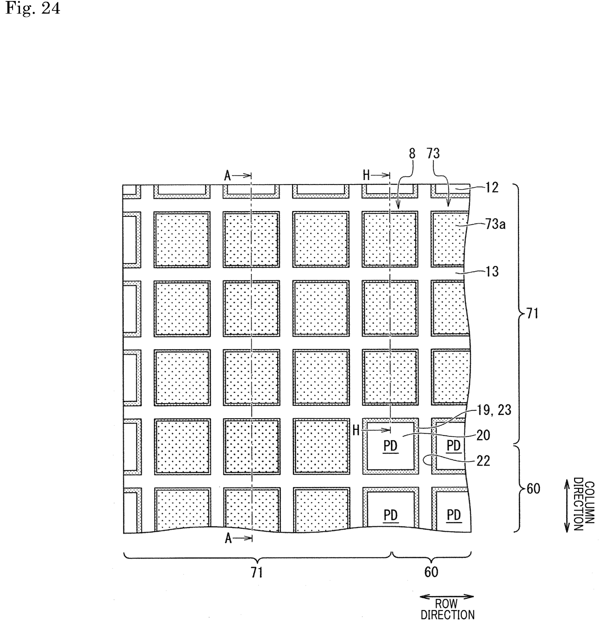

   Fig. 23 is a diagram illustrating a sectional configuration of a solid-state imaging device according to a second embodiment taken at the position corresponding to the line H-H in Fig. 24.
[Fig. 24]
   Fig. 24 is a diagram illustrating a positional relationship in a planar configuration between a semiconductor substrate and a connecting portion in a view in a thickness direction of the semiconductor substrate.
[Fig. 25]

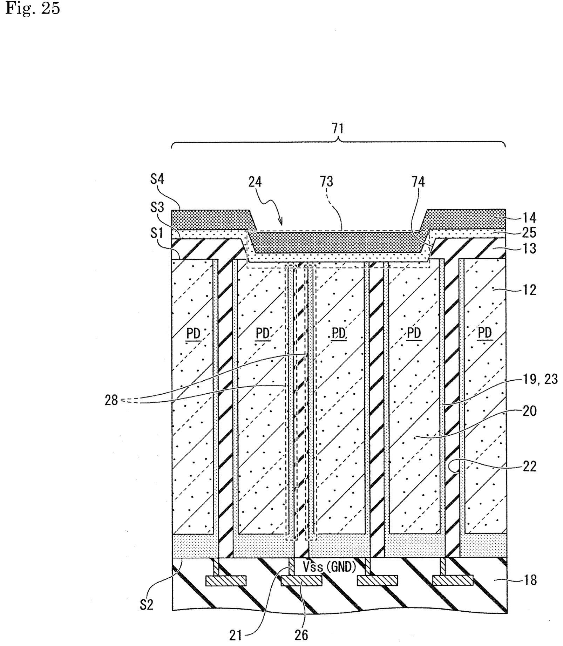

   Fig. 25 is a diagram illustrating a sectional configuration of a solid-state imaging device according to a comparative example.
[Fig. 26]

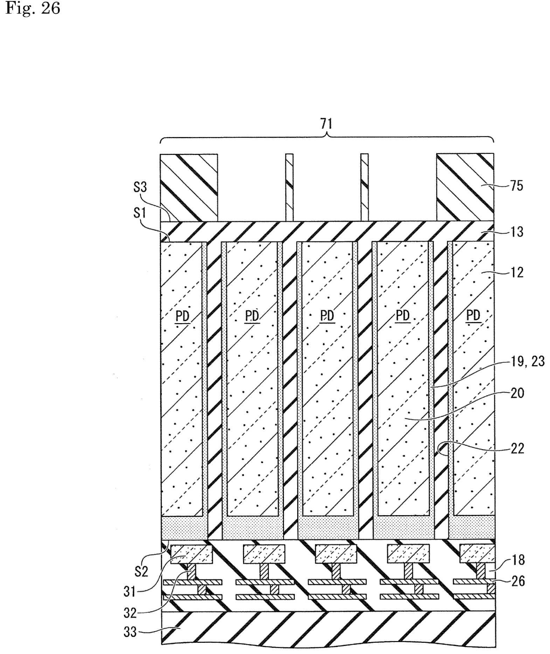

   Fig. 26 is a diagram illustrating a method of manufacturing a solid-state imaging device.
[Fig. 27]

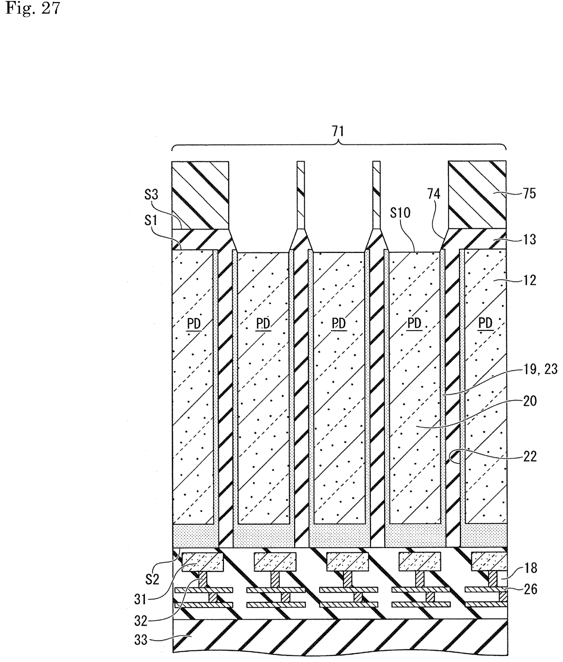

   Fig. 27 is a diagram illustrating the method of manufacturing a solid-state imaging device.
[Fig. 28]

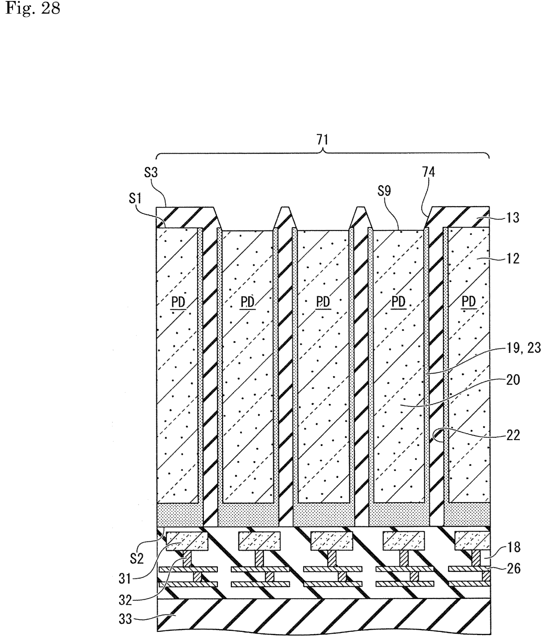

   Fig. 28 is a diagram illustrating the method of manufacturing a solid-state imaging device.
[Fig. 29]

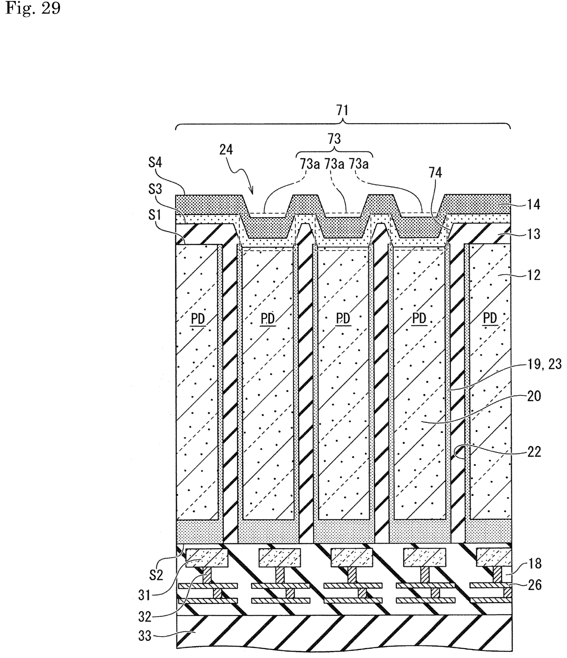

   Fig. 29 is a diagram illustrating the method of manufacturing a solid-state imaging device.
[Fig. 30]

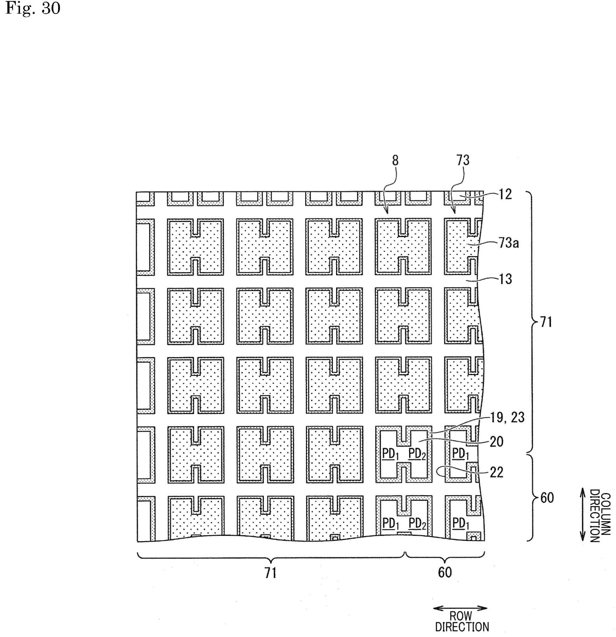

   Fig. 30 is a diagram illustrating a planar configuration of a connecting portion in a modification example (1).
[Fig. 31]

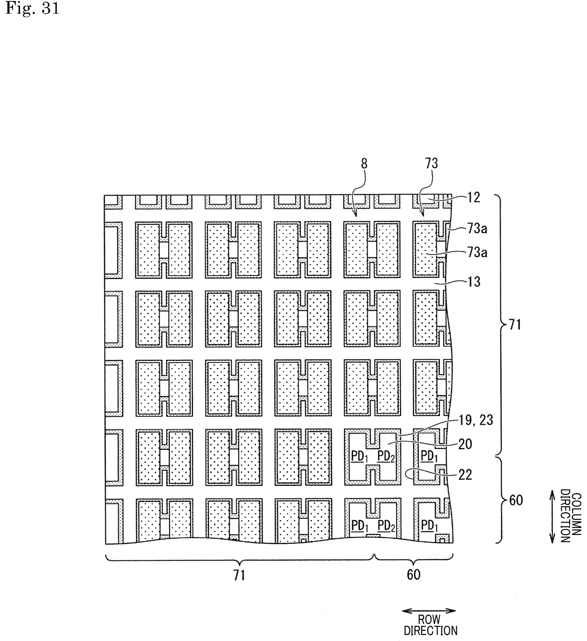

   Fig. 31 is a diagram illustrating the planar configuration of the connecting portion in the modification example (1).
[Fig. 32]

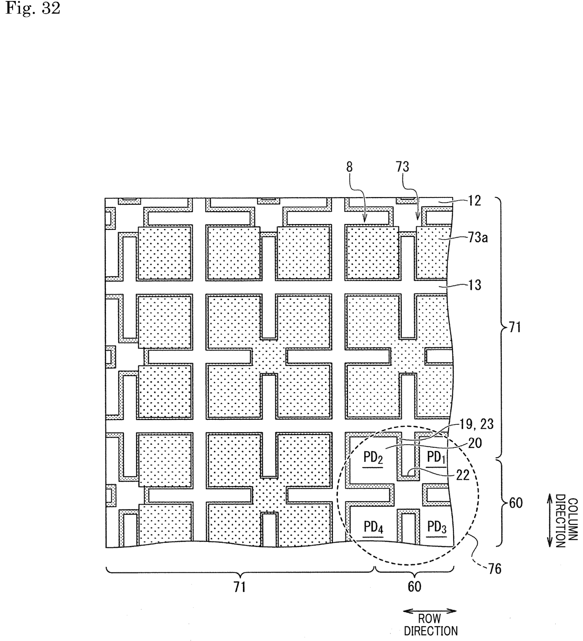

   Fig. 32 is a diagram illustrating a planar configuration of a connecting portion in a modification example (2).
[Fig. 33]

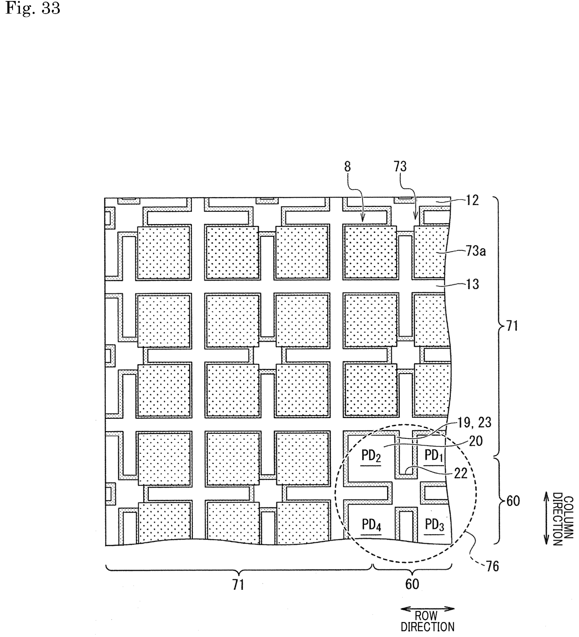

   Fig. 33 is a diagram illustrating the planar configuration of the connecting portion in the modification example (2).
[Fig. 34]

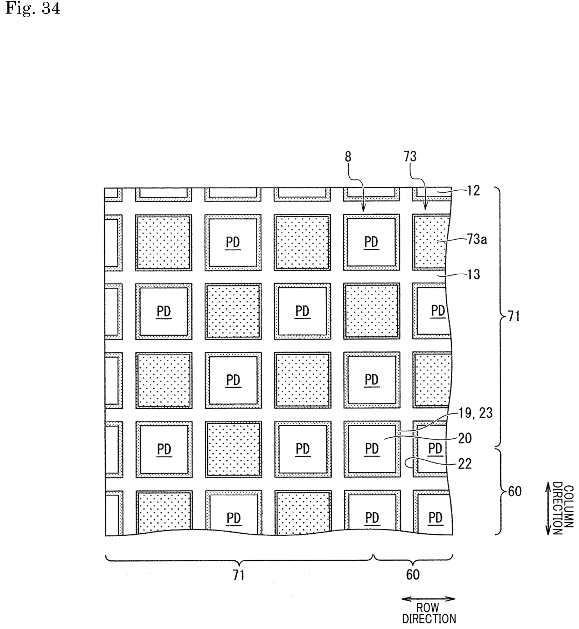

   Fig. 34 is a diagram illustrating a planar configuration of a connecting portion in a modification example (3).
[Fig. 35]

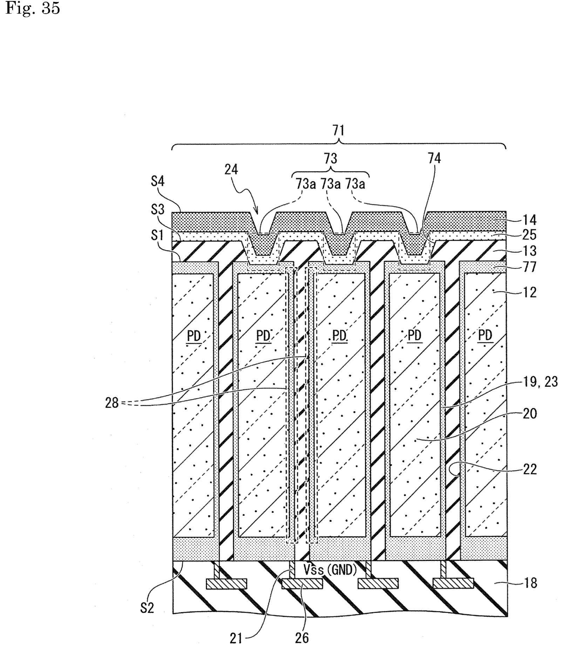

   Fig. 35 is a diagram illustrating a sectional configuration of a solid-state imaging device according to a modification example (4).
[Fig. 36]

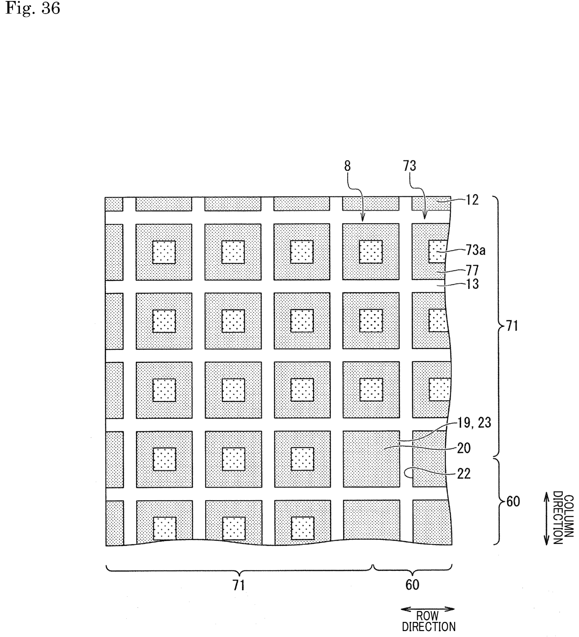

   Fig. 36 is a diagram illustrating a positional relationship in a planar configuration between a semiconductor substrate and a connecting portion in a view in a thickness direction of the semiconductor substrate.
[Fig. 37]

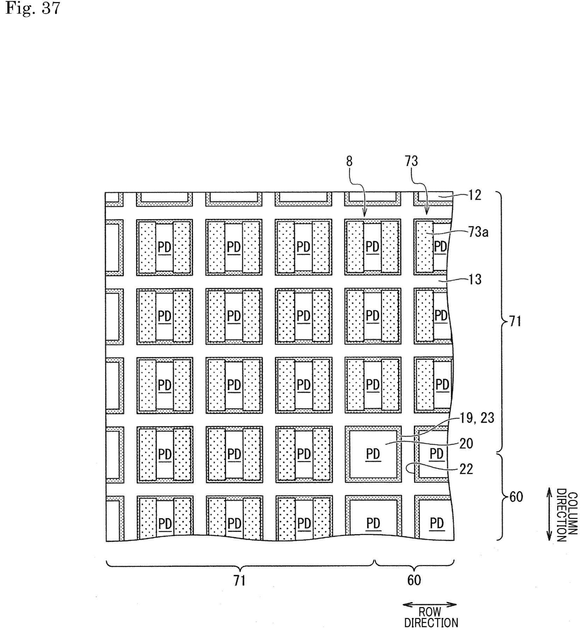

   Fig. 37 is a diagram illustrating a planar configuration of a connecting portion in a modification example (5).
[Fig. 38]

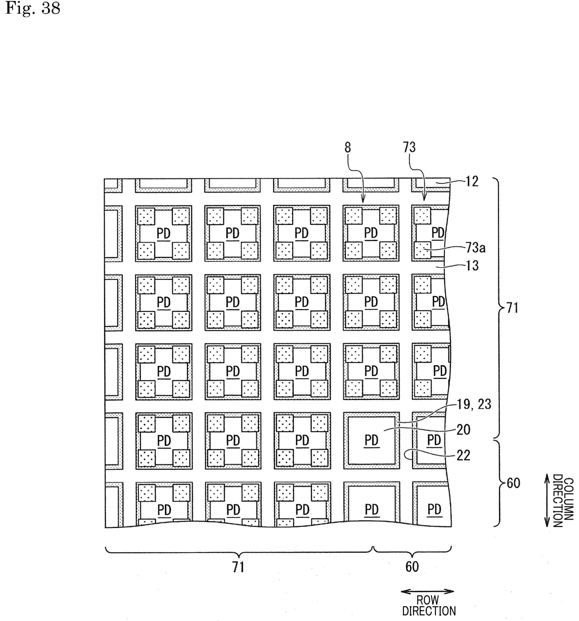

   Fig. 38 is a diagram illustrating the planar configuration of the connecting portion in the modification example (5).
[Fig. 39]

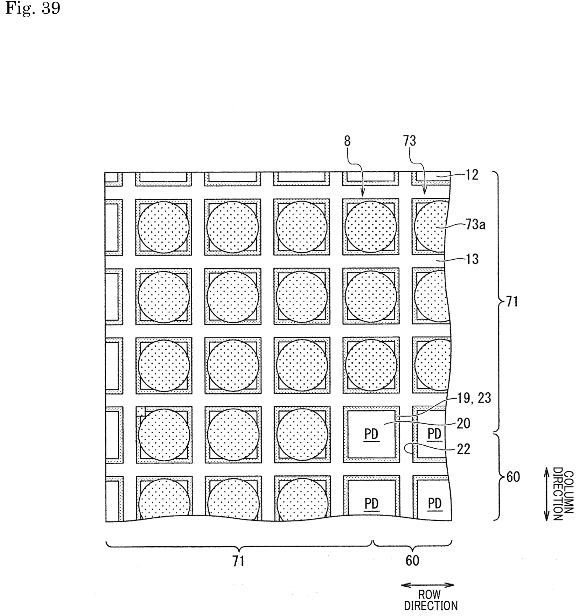

   Fig. 39 is a diagram illustrating a planar configuration of a connecting portion in a modification example (6).
[Fig. 40]

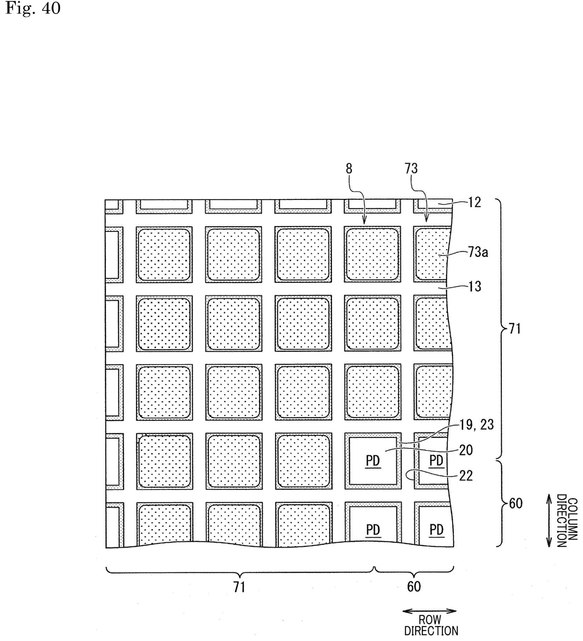

   Fig. 40 is a diagram illustrating the planar configuration of the connecting portion in the modification example (6).
[Fig. 41]

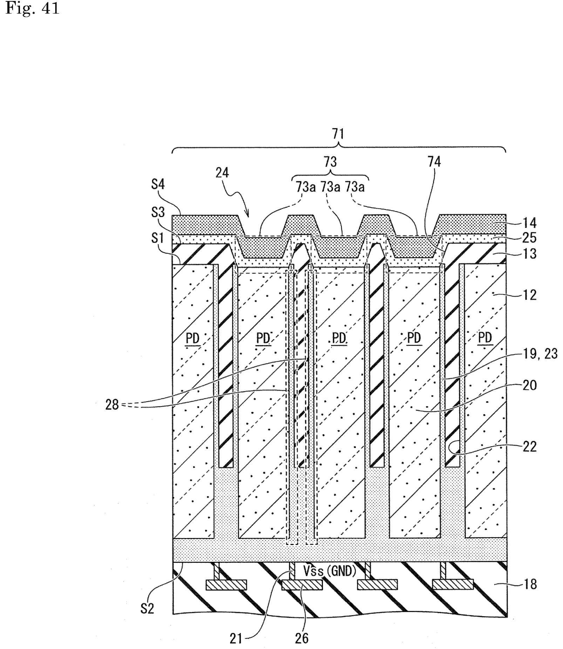

   Fig. 41 is a diagram illustrating a sectional configuration of a solid-state imaging device according to a modification example (7).
[Fig. 42]

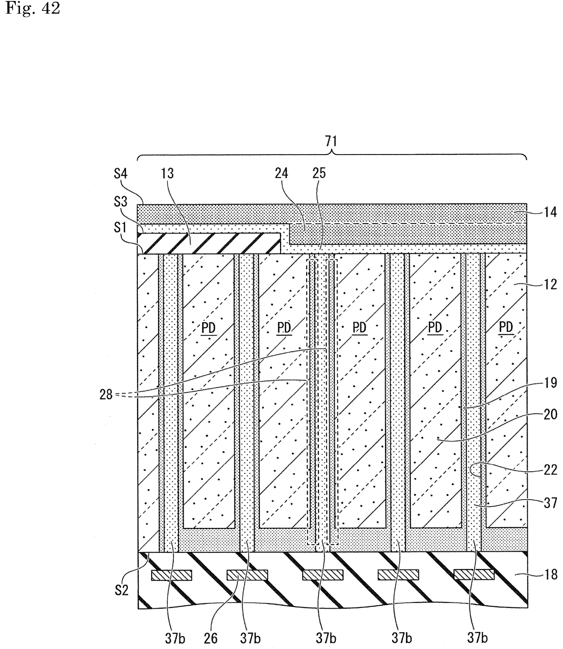

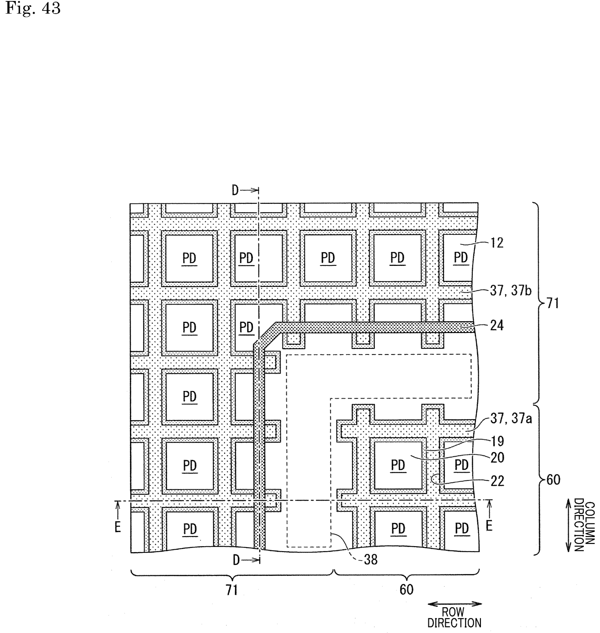

   Fig. 42 is a diagram illustrating a sectional configuration of a solid-state imaging device according to a third embodiment taken along the line D-D in Fig. 43.
[Fig. 43]
   Fig. 43 is a diagram illustrating a positional relationship in a planar configuration between a semiconductor substrate and a contact in a view in a thickness direction of a semiconductor substrate.
[Fig. 44]

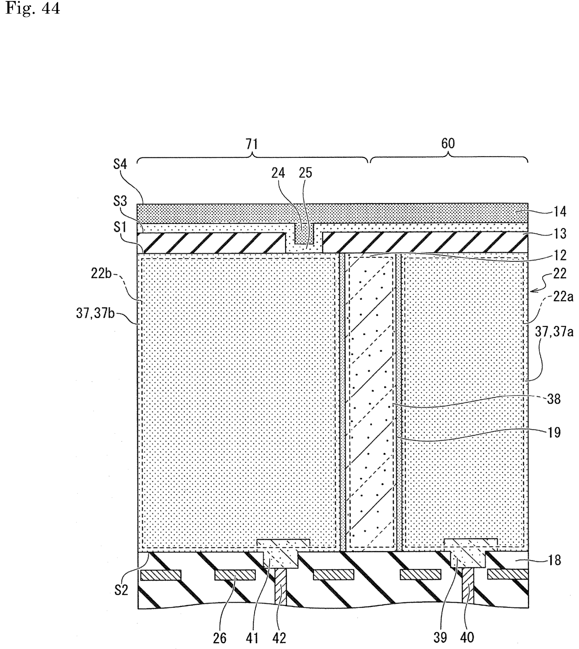

   Fig. 44 is a diagram illustrating a sectional configuration of the solid-state imaging device taken along the line E-E in Fig. 43.
[Fig. 45]

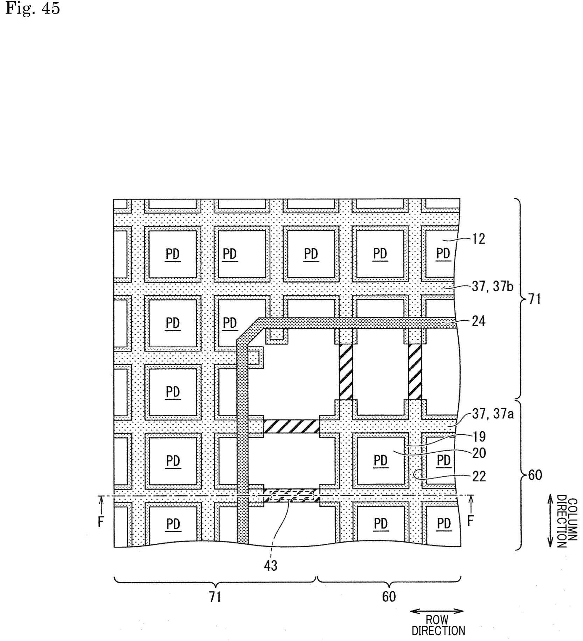

   Fig. 45 is a diagram illustrating a planar configuration of a connecting portion in a modification example (1).
[Fig. 46]

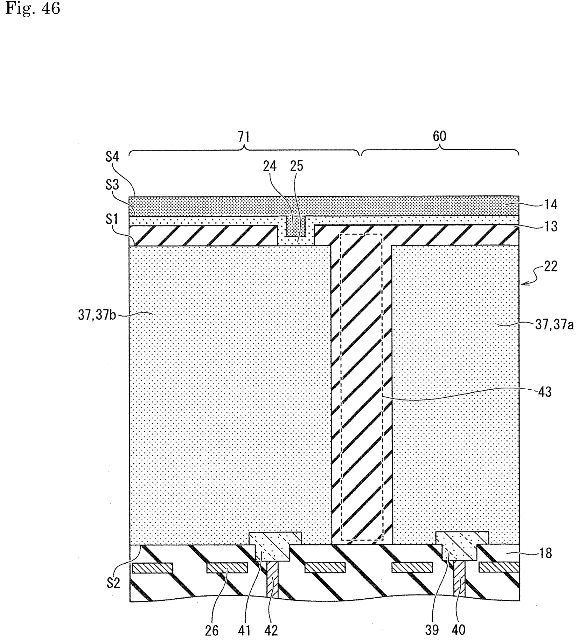

   Fig. 46 is a diagram illustrating a sectional configuration of the solid-state imaging device taken along the line F-F in Fig. 45.
[Fig. 47]

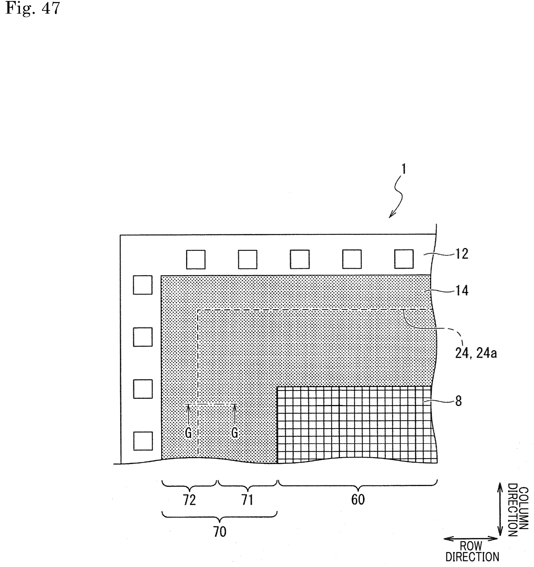

   Fig. 47 is a diagram illustrating a planar configuration at one of four corners of a pixel region 2 according to a fourth embodiment.
[Fig. 48]

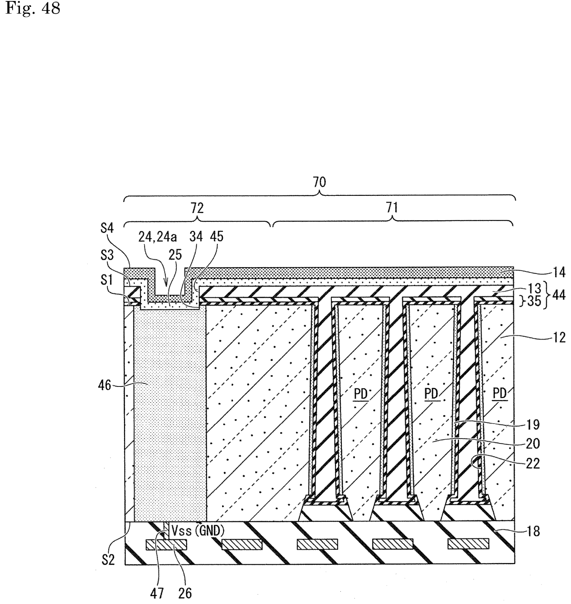

   Fig. 48 is a diagram illustrating a sectional configuration of a solid-state imaging device taken along the line G-G in Fig. 47.
[Fig. 49]

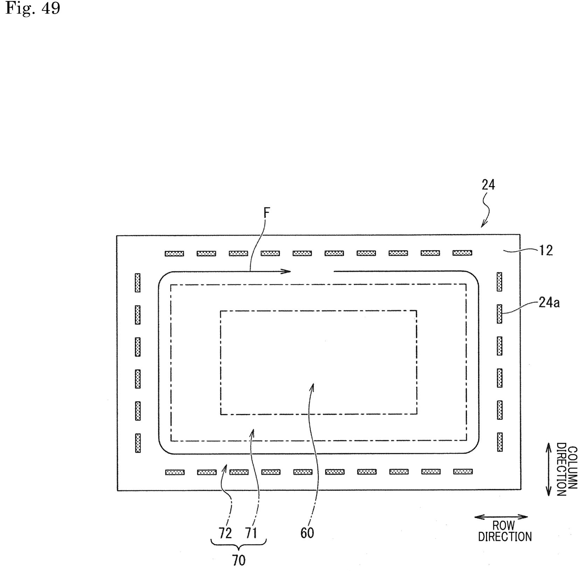

   Fig. 49 is a diagram illustrating a planar configuration of a connecting portion.
[Fig. 50]

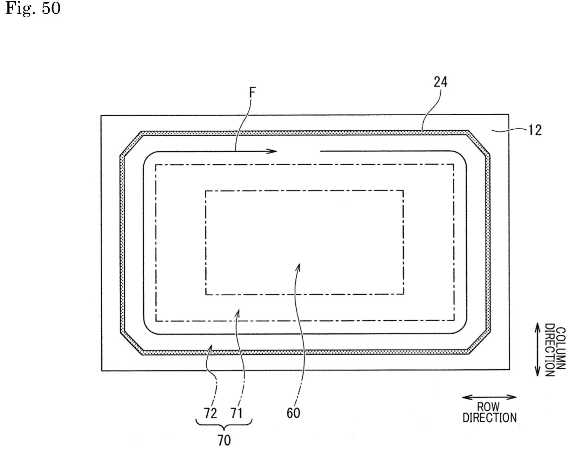

   Fig. 50 is a diagram illustrating a planar configuration of a connecting portion according to a comparative example.
[Fig. 51]

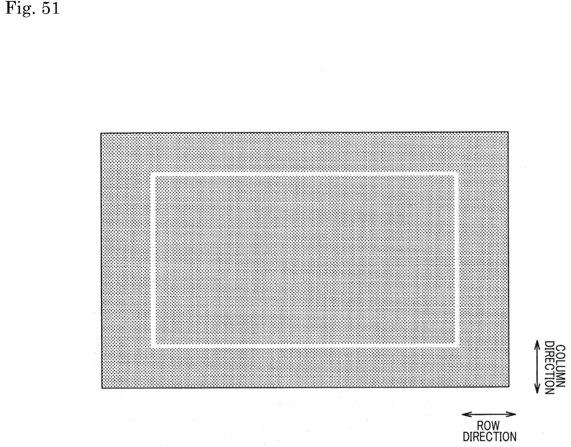

   Fig. 51 is a diagram illustrating a captured image obtained on the basis of charges in photoelectric conversion units in an effective pixel region and a light shielding pixel region in a state where light incident on the effective pixel region is blocked in a case where the configuration in the comparative example is adopted.
[Fig. 52]

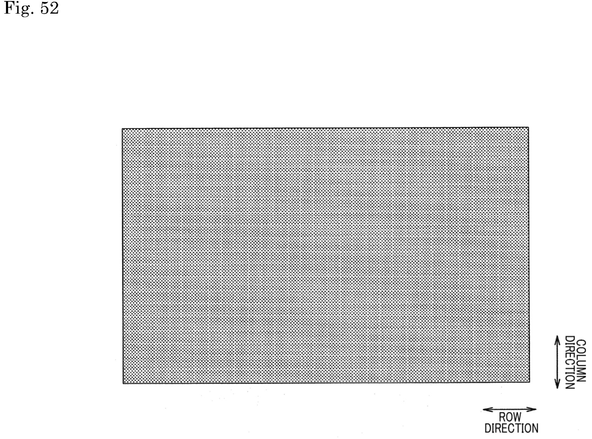

   Fig. 52 is a diagram illustrating a captured image obtained on the basis of charges in photoelectric conversion units in an effective pixel region and a light shielding pixel region in a state where light incident on the effective pixel region is blocked in a case where the configuration in the fourth embodiment is adopted.
[Fig. 53]

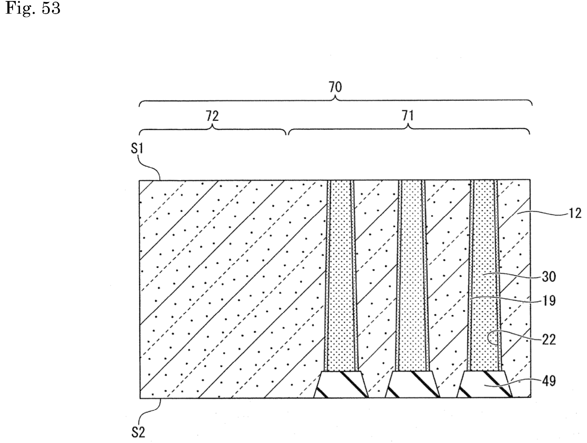

   Fig. 53 is a diagram illustrating a method of manufacturing a solid-state imaging device.
[Fig. 54]

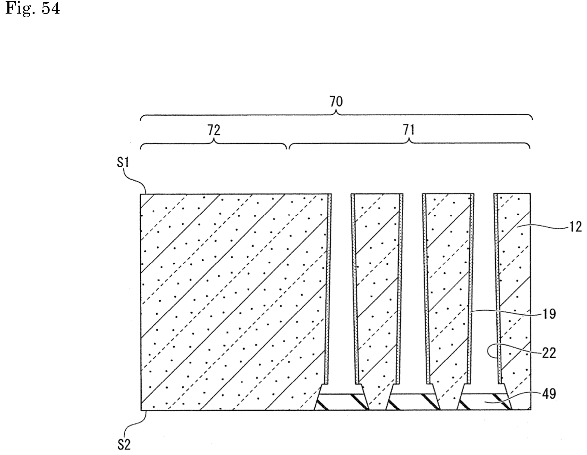

   Fig. 54 is a diagram illustrating the method of manufacturing a solid-state imaging device.
[Fig. 55]

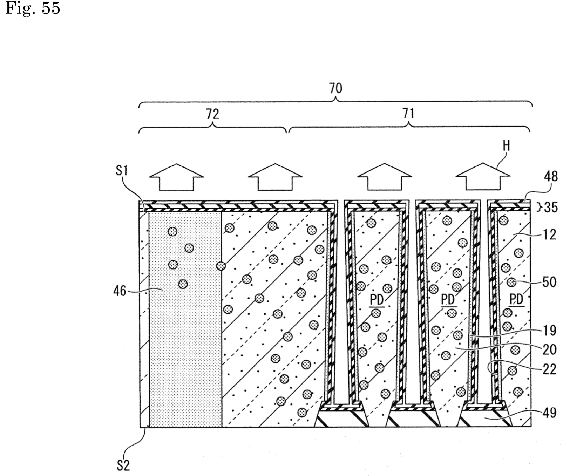

   Fig. 55 is a diagram illustrating the method of manufacturing a solid-state imaging device.
[Fig. 56]

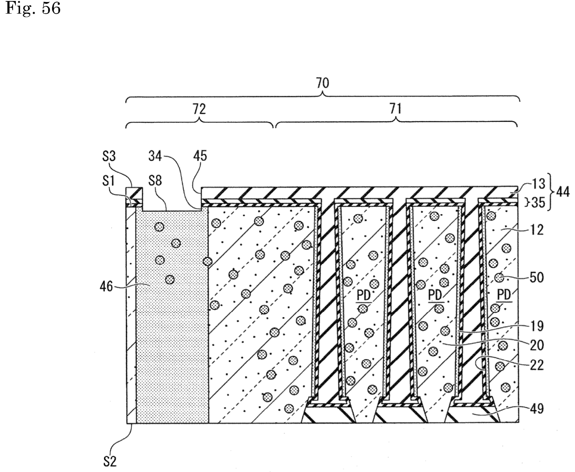

   Fig. 56 is a diagram illustrating the method of manufacturing a solid-state imaging device.
[Fig. 57]

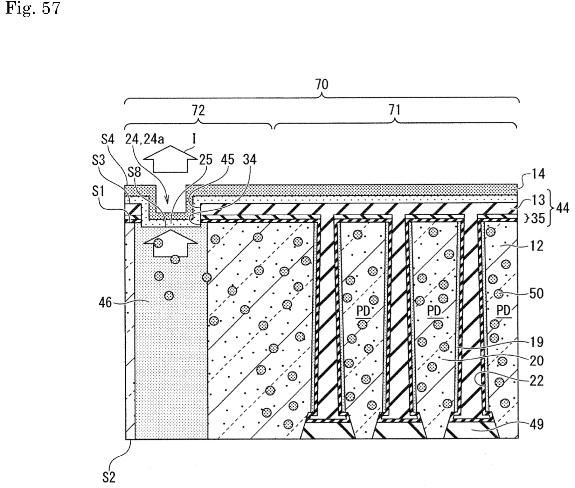

   Fig. 57 is a diagram illustrating the method of manufacturing a solid-state imaging device.
[Fig. 58]

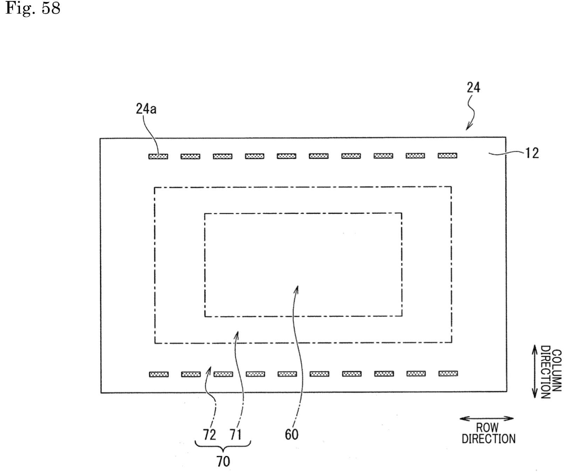

   Fig. 58 is a diagram illustrating a planar configuration of a connecting portion in a modification example (2).
[Fig. 59]

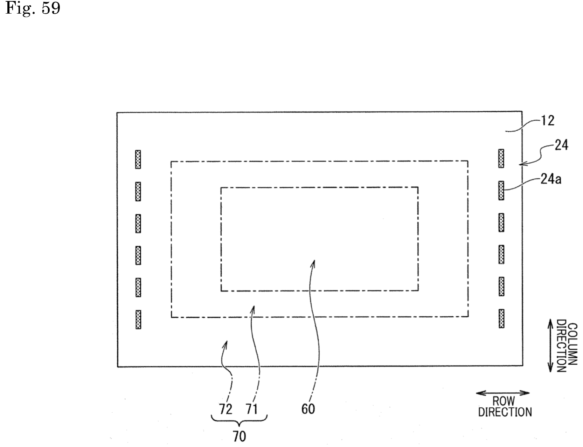

   Fig. 59 is a diagram illustrating the planar configuration of the connecting portion in the modification example (2).
[Fig. 60]

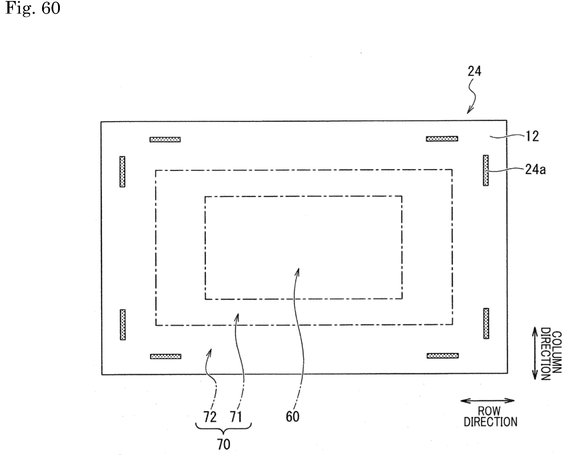

   Fig. 60 is a diagram illustrating a planar configuration of a connecting portion in a modification example (3).
[Fig. 61]

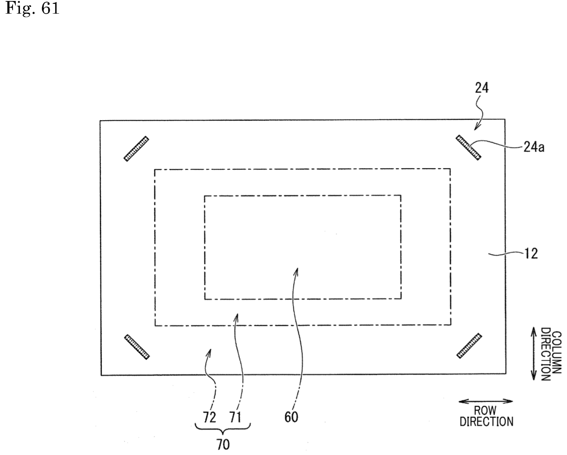

   Fig. 61 is a diagram illustrating the planar configuration of the connecting portion in the modification example (3).
[Fig. 62]

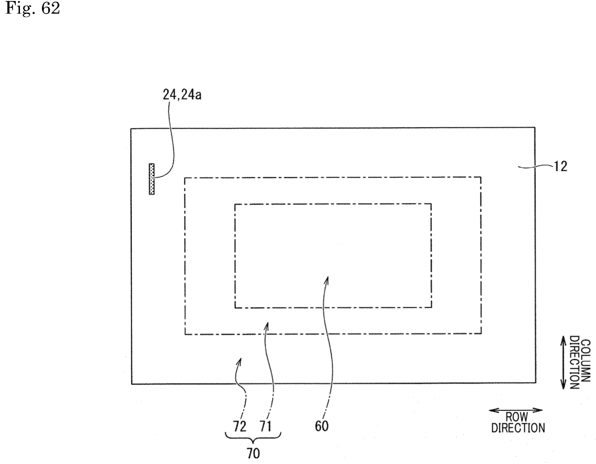

   Fig. 62 is a diagram illustrating the planar configuration of the connecting portion in the modification example (3).
[Fig. 63]

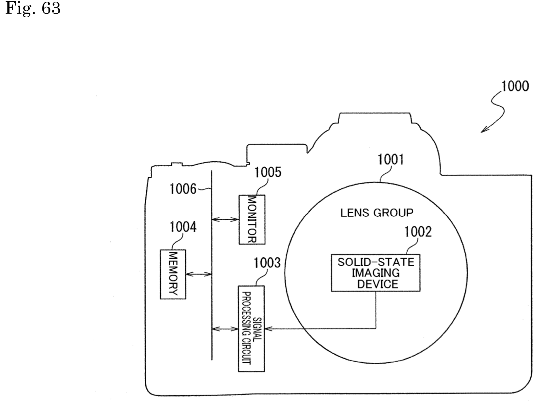

   Fig. 63 is diagram illustrating a schematic configuration of an electronic device according to a fifth embodiment.
[Fig. 64]

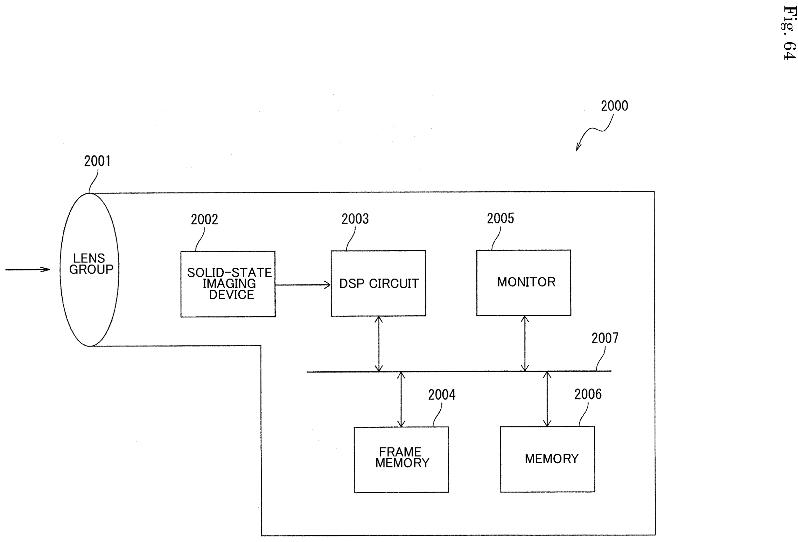

   Fig. 64 is diagram illustrating the schematic configuration of the electronic device according to the fifth embodiment.

### [Description of Embodiments]

Hereinafter, examples of a light detection device and an electronic device according to embodiments of the present disclosure will be described with reference to Figs. 1 to 64. The embodiments of the present disclosure will be described in the following order. Note that the present disclosure is not limited to the following examples. In addition, the effects described in the present specification are merely illustrative and not limiting, and other effects may be obtained.

1. First embodiment: solid-state imaging device
   1-1 Overall configuration of solid-state imaging device
   1-2 Configuration of main components
   1-3 Method of manufacturing solid-state imaging device
   1-4 Modification examples
2. Second embodiment: solid-state imaging device
   2-1 Configuration of main components
   2-2 Method of manufacturing solid-state imaging device
   2-3 Modification examples
3. Third embodiment: solid-state imaging device
   3-1 Configuration of main components
   3-2 Modification examples
4. Fourth embodiment: solid-state imaging device
   4-1 Configuration of main components
   4-2 Method of manufacturing solid-state imaging device
   4-3 Modification examples
5. Fifth embodiment: example of application to electronic device

### <1. First embodiment>

### [1-1 Overall configuration of solid-state imaging device]

A solid-state imaging device 1 (a "light detection device in a broad sense) according to a first embodiment of the present disclosure will be described. Fig. 1 is a diagram illustrating an overall configuration of the solid-state imaging device 1 according to the first embodiment.

The solid-state imaging device 1 in Fig. 1 is a rear surface illuminated-type complementary metal oxide semiconductor (CMOS) image sensor. As illustrated in Fig. 63, the solid-state imaging device 1 (1002) captures image light (incident light) from a subject through a lens group 1001, converts the amount of light of incident light, an image of which has been formed on an imaging surface, into an electrical signal in units of pixels, and outputs the electrical signal as a pixel signal.

As illustrated in Fig. 1, the solid-state imaging device 1 includes a pixel region 2, a vertical drive circuit 3, a column signal processing circuit 4, a horizontal drive circuit 5, an output circuit 6, and a control circuit 7.

The pixel region 2 includes a plurality of pixels 8 disposed in a two-dimensional array. Each pixel 8 includes a photoelectric conversion unit PD (see Fig. 3), a plurality of pixel transistors (a transfer transistor, a reset transistor, an amplification transistor, and a selection transistor, for example). As illustrated in Fig. 2, the pixel region 2 includes an effective pixel region 60 and a light shielding pixel region 71 located around the effective pixel region 60. The light shielding pixel region 71 includes, as light shielding pixels, optical black (OPB) pixels to obtain a reference signal of an optical black level and dummy pixels. The vertical drive circuit 3 is configured of, for example, a shift register, sequentially selects each pixel 8 in the pixel region 2 in units of rows by sequentially outputting a selection pulse to a pixel drive wiring 9 or the like, and outputs a pixel signal of the selected pixel 8 to the column signal processing circuit 4 through a vertical signal line 10. The pixel signal is a signal obtained from a charge (an electron, for example) generated by the photoelectric conversion unit PD.

For example, the column signal processing circuit 4 is disposed for each of the columns of pixels 8 to perform signal processing such as noise removal on signals output from the pixels 8 in one row for each pixel column. As the signal processing, it is possible to adopt correlated double sampling (CDS) and analog digital (AD) conversion to remove fixed pattern noise specific to pixels, for example.

The horizontal drive circuit 5 is configured of, for example, a shift register, and sequentially outputs horizontal scanning pulses to the column signal processing circuit 4, selects each column signal processing circuit 4 in order, and causes the selected column signal processing circuit 4 to output a pixel signal after signal processing to a horizontal signal line 11.

The output circuit 6 performs signal processing on the pixel signal sequentially output from each column signal processing circuit 4 through the horizontal signal line 11 and outputs the pixel signal. As the signal processing, it is possible to use various kinds of digital signal processing such as buffering, black level adjustment, and column fluctuation correction, for example. As the black level adjustment, it is possible to adopt, for example, processing of correcting a black level of the pixel signal to "0" by subtracting a reference signal of an optical black level obtained from a pixel 8 (OPB pixel) in a light shielding pixel region 71 from the pixel signal obtained from a pixel 8 (effective pixel) in an effective pixel region 60.

The control circuit 7 generates a clock signal and a control signal as references for operations of the vertical drive circuit 3, the column signal processing circuit 4, the horizontal drive circuit 5, and the like on the basis of a vertical synchronization signal, a horizontal synchronization signal, and a master clock signal (not illustrated). The control circuit 7 then outputs the generated clock signals and control signals to the vertical drive circuit 3, the column signal processing circuit 4, the horizontal drive circuit 5, and the like.

### [1-2 Configuration of main components]

Next, a detailed structure of the solid-state imaging device 1 will be described. Fig. 2 is a diagram illustrating a planar configuration at one of four corners of the pixel region 2. Fig. 2 is illustrated with a structure (including an on-chip lens) above a light shielding film 14 omitted in order to make the light shielding film 14 clear. Fig. 3 is a diagram illustrating a sectional configuration of the solid-state imaging device 1 taken along the line A-A in Figs. 2 and 4. As illustrated in Fig. 3, the solid-state imaging device 1 includes a semiconductor substrate 12, and an insulating film 13 and the light shielding film 14 are stacked in this order on a light receiving surface (hereinafter, also referred to as a "rear surface S1"; a "first surface" in a broad sense) of the semiconductor substrate 12. Note that although nothing is illustrated on the side of a rear surface S4 of the light shielding film 14 in Fig. 3, a flattening film, a color filter, an on-chip lens, and the like may be formed. The color filter and the on-chip lens are formed only in the effective pixel region 60 in the semiconductor substrate 12 and are not formed in the light shielding pixel region 71. Also, a wiring layer 18 is disposed on the surface (hereinafter, also referred to as a "front surface S2"; a "second surface" in a broad sense) of the semiconductor substrate 12 on the side opposite to the rear surface S1.

The semiconductor substrate 12 is a substrate configured of, for example, silicon (Si). In the semiconductor substrate 12, a photoelectric conversion unit PD is formed in each region corresponding to each pixel 8. In other words, a plurality of photoelectric conversion units PD are formed in a two-dimensional array in the semiconductor substrate 12. Each photoelectric conversion unit PD includes a first conductivity-type region 19 which is a semiconductor region of a first conductivity type (a p type, for example) and a second conductivity-type region 20 that is a semiconductor region of a second conductivity type (a conductivity type opposite to the first conductivity type; an n type, for example) that forms a pn junction with the first conductivity-type region 19. The first conductivity-type region 19 is continuously formed entirely on the side of an inner wall surface of a trench portion 29, which will be described later, and entirely on the side of the front surface S2 of the semiconductor substrate 12. Also, the second conductivity-type region 20 is formed in a region on the center side such that the second conductivity-type region 20 is in contact with the first conductivity-type region 19. The photoelectric conversion unit PD configures a photodiode through a pn junction between the first conductivity-type region 19 and the second conductivity-type region 20, photoelectrically converts incident light, and generates a charge (an electron, for example). Also, the photoelectric conversion unit PD accumulates the generated charge in an electrostatic capacity generated through the pn junction. The first conductivity-type region 19 is electrically connected to a supply source of a ground potential Vss (GND). Fig. 2 illustrates an exemplary case in which a contact 21 is connected to a part of the first conductivity-type region 19 on the side of the front surface S2 at each photoelectric conversion unit PD and the first conductivity-type region 19 is connected to the potential supply source of the ground potential Vss via the contact 21, and a wiring 26 of the wiring layer 18.

In the semiconductor substrate 12, a trench portion 22 is formed in a region between the photoelectric conversion units PD. In other words, the trench portion 22 is formed in a grid shape to surround each photoelectric conversion unit PD. The trench portion 22 is a penetrating trench portion that penetrates through the semiconductor substrate 12 in the thickness direction of the semiconductor substrate 12. In other words, it is also possible to state that the trench portion 22 is a trench portion formed to penetrate through the semiconductor substrate 12 from the rear surface S1 to the front surface S2. Also, the above-mentioned p-type first conductivity-type region 19 of the photoelectric conversion unit PD is formed on the inner wall surface (the part of the semiconductor substrate 12 configuring the inner wall surface) of the trench portion 22, and the first conductivity-type region 19 configures the hole accumulation region 23 where holes are accumulated. The hole accumulation region 23 is continuously formed from the rear surface S1 to the front surface S2 of the semiconductor substrate 12 by being configured of the first conductivity-type region 19.

Also, an insulating film 13 is embedded in the space inside of the trench portion 22. The adjacent photoelectric conversion units PD are electrically insulated by the insulating film 13 being embedded therein, and movement of the charge between the photoelectric conversion units PD is prevented. As a material of the insulating film 13, it is possible to adopt silicon oxide (SiO₂) or silicon nitride (SiN), for example. Also, the insulating film 13 is embedded in the space inside of the trench portion 22 and also continuously entirely covers the side of the rear surface S1 of the semiconductor substrate 12.

The light shielding film 14 is disposed on the side of the rear surface S3 of the insulating film 13 and covers a part of the rear surface S3 of the insulating film 13. Specifically, the light shielding film 14 is formed into a grid shape with each photoelectric conversion unit PD on the side of the rear surface S1 opening in the effective pixel region 60 in the semiconductor substrate 12 and shields light in the region between the photoelectric conversion units PD as illustrated in Figs. 2 and 3. The light shielding film 14 does not include any opening corresponding to each photoelectric conversion unit PD in the light shielding pixel region 71 and shields light in the entire light shielding pixel region 71. As a material of the light shielding film 14, it is possible to adopt tungsten (W), aluminum (Al), or copper (Cu), for example.

Further, a contact 24 (a "connecting portion" in a broad sense) is disposed between the rear surface S1 of the light shielding pixel region 71 of the semiconductor substrate 12 and the light shielding film 14 as illustrated in Fig. 3. Fig. 3 illustrates an exemplary case in which the contact 24 is formed in a strip shape integrated with the light shielding film 14. As illustrated in Fig. 4, the contact 24 is disposed in a polygonal frame shape that surrounds the periphery of the effective pixel region 60 and has an obtuse angle at each corner in a view in the thickness direction of the semiconductor substrate 12. It is thus possible to curb an increase in line width of the contact 24 at the corners of the contact 24. Therefore, it is possible to curb deepening of a groove 34 (see Fig. 12) at the corners when the groove 34 with the shape of the contact 24 is formed in the light shielding film 14 in a formation process of the contact 24. Therefore, it is possible to curb working damage on the trench portion 22 and to curb degradation of dark current properties. Furthermore, since each part of the contact 24 has a linear shape, it is possible to increase the connecting area between the contact 24 and the first conductivity-type region 19 and to more appropriately curb occurrence of arcing in the manufacturing process.

Fig. 4 illustrates an exemplary case where the linearly extending part of the contact 24 is shifted in the trench width direction from the linearly extending part of the trench portion 22 in a view in the thickness direction of the semiconductor substrate 12. Fig. 4 is a diagram illustrating a positional relationship in a planar configuration between the semiconductor substrate 12 and the contact 24 in a view in the thickness direction of the semiconductor substrate 12. In Fig. 4, layers such as the light shielding film 14 and a barrier metal layer 25 is omitted to make the positional relationship therebetween clear. Also, the contact 24 is electrically connected to the first conductivity-type region 19 in the semiconductor substrate 12 via the barrier metal layer 25. In this manner, the contact 24 causes the light shielding film 14 to be electrically connected to the first conductivity-type region 19 and causes the light shielding film 14 to be connected to the potential supply source of the ground potential Vss via the first conductivity-type region 19, the contact 21, and the wiring 26 of the wiring layer 18. Also, it is possible to prevent metal atoms in the insulating film 13 from spreading to the inside of the semiconductor substrate 12 by sandwiching the barrier metal layer 25 between the contact 24 and the first conductivity-type region 19 (semiconductor substrate 12). As a material of the barrier metal layer 25, it is possible to adopt titanium (Ti) or titanium nitride (TiN), for example. The wiring layer 18 includes interlayer insulating films and wirings 26 stacked in a plurality of layers via the interlayer insulating films and drives a pixel transistor (not illustrated) of each pixel 8 via the wirings 26 in the plurality of layers.

In the solid-state imaging device 1 with the above configuration, light is incident from the side of the rear surface S1 of the semiconductor substrate 12, the incident light is transmitted through the on-chip lens (not illustrated) and the color filter, and the transmitted light is photoelectrically converted by the photoelectric conversion unit PD, thereby generating a charge. Then, the generated charge is output as a pixel signal from the vertical signal line 10 (see Fig. 1) formed by the wirings 26 in the wiring layers 18.

Here, there is a likelihood that abnormal discharge called arcing may occur in the light shielding film 14 due to electrification occurring in the manufacturing process or the like in a case where the light shielding film 14 is electrically floating, for example. Then, breakage of the light shielding film 14 and defects (film thickness unevenness, cracking, and pin holes) in film formation due to charged dust collection may occur, and this may lead to manufacturing failure and image quality degradation. On the other hand, the solid-state imaging device 1 according to the first embodiment is configured such that the light shielding film 14 is electrically connected to the ground potential Vss (GND) via the contact 24 and the first conductivity-type region 19 (hole accumulation region). It is thus possible to prevent arcing from occurring in the light shielding film 14 in the manufacturing process, for example. Therefore, it is possible to curb breakage and the like of the light shielding film 14 and to obtain an image with better image quality.

Also, a case where a configuration (a configuration in a comparative example) in which a p-type semiconductor region (hereinafter, also referred to as a "p-well region 27") is formed in a region (hereinafter, also referred to as an "outer region 72") on the side further outward than the light shielding pixel region 71 in the semiconductor substrate 12 is formed and the contact 24 is formed at a position of the formed p-well region 27 facing the rear surface S1 is adopted in order to prevent arching as illustrated in Figs. 5 and 6, for example, will be considered.

In the case where such a configuration is adopted, the chip size of the solid-state imaging device 1 may increase by the amount corresponding to the size of the outer region 72 (corresponding to the sizes of the p-well region 27 and the contact 24). Therefore, manufacturing costs of the solid-state imaging device 1 may increase. Furthermore, a process for forming the p-well region 27 is required, which may lead to an increase in the number of processes. Fig. 6 is a diagram illustrating a positional relationship in a planar configuration between the semiconductor substrate 12 and the contact 24 in a view in the thickness direction of the semiconductor substrate 12. In Fig. 6, layers such as the light shielding film 14 and the barrier metal layer 25 are omitted similarly to Fig. 4 to make the positional relationship therebetween clear.

On the other hand, the solid-state imaging device 1 according to the first embodiment is configured such that the contact 24 is disposed between the rear surface S1 of the light shielding pixel region 71 of the semiconductor substrate 12 and the light shielding film 14 as illustrated in Fig. 3. Therefore, it is possible to curb an increase in chip size by the amount corresponding to the outer region 72 (such as the p-well region 27) as compared with a case where the p-well region 27 and the contact 24 are formed in the region (the outer region 72 illustrated in Figs. 5 and 6) on the side further outward than the light shielding pixel region 71, for example. Therefore, it is possible to curb an increase in manufacturing costs of the solid-state imaging device 1. Furthermore, the process for forming the p-well region 27 is not required, and it is thus possible to curb an increase in the number of processes. Therefore, it is possible to cause the contact 24 for connecting the light shielding film 14 to the ground potential to have a more appropriate configuration.

In the solid-state imaging device 1 according to the first embodiment, the hole accumulation region 23 is configured of the first conductivity-type region 19 (p-type semiconductor region) formed on the inner wall of the trench portion 22. Therefore, it is possible to bring the part (hereinafter, also referred to as an "inner wall surface-side part 28") of the semiconductor substrate 12 on the side of the inner wall surface of the trench portion 22 into a high hole concentration state by forming a p-type impurity region on the inner wall surface of the trench portion 22, and to cause electrons to move inside of the inner wall surface-side part 28. Also, it is possible to apply the ground potential Vss to the semiconductor substrate 12 via the contact 24 and the inner wall surface-side part 28 by connecting the contact 24 to the ground potential Vss (GND). Furthermore, it is possible to curb occurrence of a dark current by bringing the inner wall surface-side part 28 into the high hole concentration state.

### [1-3 Method of manufacturing solid-state imaging device]

Next, a method of manufacturing the solid-state imaging device 1 according to the first embodiment will be described.

First, the trench portion 22 is formed in the front surface S2 of the semiconductor substrate 12 as illustrated in Fig. 7 by using a lithography method and a dry etching method. Then, a part (inner wall surface-side part 28) of the first conductivity-type region 19 on the side of the inner wall surface of the trench portion 22 is formed in the semiconductor substrate 12 as illustrated in Fig. 8. A process of introducing p-type impurities from the inside of the trench portion 22 can be applied to the formation of the first conductivity-type region 19. As a method of doping the p-type impurities, it is possible to adopt, for example, a solid-phase diffusion method, plasma doping, or an ion implanting injection method. Subsequently, polysilicon 30 is embedded in the space inside of the trench portion 22.

Subsequently, the rest part of the first conductivity-type region 19 and the second conductivity-type region 20 are formed in the semiconductor substrate 12 as illustrated in Fig. 9 by using an ion injection technology. In this manner, each photoelectric conversion unit PD including the first conductivity-type region 19 and the second conductivity-type region 20 is formed. Subsequently, the wiring layer 18 including gates 31 of pixel transistors, contacts 32, the wirings 26, and a Cu-Cu junction pad (not illustrated) is formed as illustrated in Fig. 10. Note that although illustration is omitted in Fig. 10, the contact 21 illustrated in Fig. 3 is also formed in a case where the contact 21 illustrated in Fig. 3 is used to supply the ground potential Vss (GND) to the first conductivity-type region 19. Subsequently, a Cu-Cu junction between the wiring layer 18 and a logic substrate 33 is performed via the pad in the wiring layer 18 as illustrated in Fig. 11. Subsequently, the polysilicon 30 is removed from the inside of the trench portion 22, the insulating film 13 is formed inside of the trench portion 22 and on the rear surface S1 of the semiconductor substrate 12, and the groove 34 penetrating through the insulating film 13 is then formed at a position where the insulating film 13 in the light shielding pixel region 71 and the contact 24 in the semiconductor substrate 12 are scheduled to be formed as illustrated in Fig. 12. In this manner, the first conductivity-type region 19 is exposed in a bottom surface S6 of the groove 34.

Subsequently, the barrier metal layer 25 and the contact 24 are formed in the groove 34, and the light shielding film 14 is formed on the rear surface S3 of the insulating film 13 as illustrated in Fig. 13. In this manner, the light shielding film 14 is electrically connected to the ground potential Vss (GND) via the contact 24 and the first conductivity-type region 19 (hole accumulation region 23). Therefore, it is possible to prevent arcing from occurring in the light shielding film 14 in sputtering or the like in a later process. Subsequently, various configurations (a flattening film, a color filter, and an on-chip lens, for example) on the side of the rear surface S4 of the light shielding film 14 are formed. The solid-state imaging device 1 illustrated in Fig. 3 is manufactured through such a procedure.

### [1-4 Modification examples]

(1) Note that although the example in which the hole accumulation region 23 is configured of the first conductivity-type region 19 (p-type semiconductor region) formed on the inner wall of the trench portion 22 has been described in the first embodiment, it is also possible to adopt other configurations. For example, a configuration in which a fixed charge film 35 covering the entire inner wall surface of the trench portion 22 and having a negative charge is included and the hole accumulation region 23 is a region formed through induction of holes by the fixed charge film 35 as illustrated in Fig. 14 may also be adopted. In this manner, it is possible to bring the part (inner wall surface-side part 28) of the semiconductor substrate 12 on the side of the inner wall surface of the trench portion 22 into a high hole concentration state and to move electrons inside of the inner wall surface-side part 28. In this case, the hole accumulation region 23 is configured to be electrically connected to the supply source of the ground potential Vss (GND). Fig. 14 illustrates an exemplary case where the contact 21 is connected to the part of the hole accumulation region 23 on the side of the front surface S2 and the hole accumulation region 23 is connected to the potential supply source of the ground potential Vss via the contact 21 and the wirings 26 in the wiring layer 18. In this manner, it is possible to apply the ground potential Vss to the semiconductor substrate 12 via the contact 24 and the hole accumulation region 23 by connecting the contact 24 to the inner wall surface-side part 28 (hole accumulation region 23). Moreover, it is possible to curb generation of a dark current by bringing the inner wall surface-side part 28 into a high hole concentration state. As a material of the fixed charge film 35, it is possible to adopt a high-refractive-index material film or a high dielectric film having a negative charge capable of generating a fixed charge and strengthening pining by forming the fixed charge film 35 on the semiconductor substrate 12, for example. Examples thereof include oxides, nitrides, and the like containing at least one element from hafnium (Hf), aluminum (Al), zirconium (Zr), tantalum (Ta), and titanium (Ti). Hafnium oxide (HfO₂) is particularly preferable from the viewpoint that hafnium oxide is less likely to peel off from the semiconductor substrate 12.
(2) Although the example in which the linearly extending part of the contact 24 is shifted in the trench width direction from the linearly extending part of the trench portion 22 has been described in the first embodiment, it is also possible to adopt other configurations. For example, the contact 24 may be configured to linearly extend with at least a part thereof overlapping the linearly extending part of the trench portion 22 in a view in the thickness direction of the semiconductor substrate 12 as illustrated in Fig. 15. Here, in a case where the semiconductor substrate 12 is thick and the trench portion 22 is deep, for example, cracking is likely to occur in the trench portion 22 if overlapping between the contact 24 and the trench portion 22 is small. On the other hand, the overlapping between the contact 24 and the trench portion 22 increases and occurrence of such cracking can be curbed in the first embodiment. Fig. 15 illustrates an exemplary case in which all parts of the contact 24 other than the four corners overlap with the trench portion 22 in a view in the thickness direction of the semiconductor substrate 12. Also, the contact 24 is formed to have a wider width than the trench portion 22 such that the contact 24 stretches over both the first conductivity-type regions 19 located on the mutually facing inner wall surfaces of the trench portion 22.
(3) Although the example in which the insulating film 13 is embedded inside of the trench portion 22 has been described in the first embodiment, it is also possible to adopt other configurations. For example, a configuration in which the polysilicon 30 is embedded inside of the trench portion 22 as illustrated in Fig. 16 may be adopted. Here, in the first embodiment, the polysilicon 30 is embedded inside of the trench portion 22, the polysilicon 30 is then removed, and the insulating film 13 is embedded in the trench portion 22 in the manufacturing process. On the other hand, according to this modification example, the configuration in which the polysilicon 30 is left inside of the trench portion 22 is adopted, and it is thus possible to omit the process of removing the polysilicon 30 from the inside of the trench portion 22. As the polysilicon 30, it is possible to adopt both doped polysilicon and non-doped polysilicon, for example.
(4) Although the example in which one photoelectric conversion unit PD is formed for one pixel 8 has been described in the first embodiment, it is also possible to adopt other configurations. For example, the semiconductor substrate 12 may be configured such that two photoelectric conversion units PD₁ and PD₂ are formed for one pixel 8 as illustrated in Fig. 17. In this manner, it is possible to detect a phase difference from outputs of the two photoelectric conversion units PD₁ and PD₂. In this case, the part of the trench portion 22 located between the two photoelectric conversion units PD₁ and PD₂ is configured to be disconnected on the center side of the pixel 8 in a view in the thickness direction of the semiconductor substrate 12.
(5) Although the example in which the contact 24 is formed into a frame shape that seamlessly and continuously surrounds the periphery of the effective pixel region 60 has been described in the first embodiment, it is also possible to adopt other configurations. For example, the contact 24 may have a configuration (hereinafter, also referred to as a "dot pattern") in which the contact 24 is divided like a dashed line to surround the periphery of the effective pixel region 60 in a view in the thickness direction of the semiconductor substrate 12 as illustrated in Fig. 18. Fig. 18 illustrates, as a dot pattern, an exemplary case in which a column of components (hereinafter, also referred to as "divided contacts 24a") of the contact 24 aligned in parallel to the column direction of the pixels 8 and a column of the divided contacts 24a aligned in parallel to the row direction of the pixel 8 are disposed to configure each of sides of the quadrangle surrounding the periphery of the effective pixel region 60 and each column is spaced apart from each other at each corner of the quadrangle. It is possible to exclude the corners from the contact 24 by each column being spaced apart from each other at each corner, and to thereby avoid an increase in line width of the contact 24 at the corner. Therefore, it is possible to keep the dept of the groove 34 constant at each part of the groove 34 and to avoid deepening of the groove 34 at each corner when the groove 34 (see Fig. 12) with the shape of the contact 24 is formed in the light shielding film 14 in the formation process of the contact 24. Therefore, it is possible to curb working damage on the trench portion 22 and to curb degradation of dark current properties. Each column of the divided contacts 24a is formed by the plurality of divided contacts 24a with the same length, the same width, and the same thickness being disposed at constant intervals in the length direction. Note that in a case where such a dot pattern is adopted, it is preferable to dispose a large number of divided contacts 24a in each column to sufficiently secure the contact area between the divided contact 24a and the first conductivity-type region 19.
   Furthermore, the contact 24 may have a configuration (dot pattern) in which the contact 24 is disposed in a divided manner at each of positions in the light shielding pixel region 71 facing vertexes at four corners of the effective pixel region 60 in a view in the thickness direction of the semiconductor substrate 12 as illustrated in Fig. 19, for example. Fig. 19 illustrates, as a dot pattern, an exemplary case in which the divided contacts 24a with a square shape are disposed at the vertexes at the four corners. Note that in a case where such a dot pattern is adopted, the contact area between the divided contacts 24a and the first conductivity-type region 19 significantly decreases, and it is thus preferable to use the solid-state imaging device 1 in which the size of the light shielding film 14 in the effective pixel region 60 is small (for example, the chip size is small).
(6) Also, the contact 24 may have a configuration (line pattern) in which the contact 24 is disposed at each of positions in the light shielding pixel region 71 facing mutually parallel two sides of the outer edge of the effective pixel region 60 in a view in the thickness direction of the semiconductor substrate 12 as illustrated in Fig. 20, for example. Fig. 20 illustrates, as a line pattern, an exemplary case in which the divided contacts 24a with an oblong shape extending in a direction parallel to the row direction are disposed at the position facing the two sides (the upper side and the lower side of the effective pixel region 60 in Fig. 20) parallel to the row direction of the pixel 8.
   Further, the contact 24 may have a configuration (line pattern) in which the contact 24 is disposed at each of positions in the light shielding pixel region 71 facing the sides of the outer edge of the effective pixel region 60 and is divided at the part facing the vertex at each corner of the effective pixel region 60 in a view in the thickness direction of the semiconductor substrate 12 as illustrated in Fig. 21, for example. Fig. 21 illustrates, as a line pattern, an exemplary case in which the divided contact 24a extending in the direction parallel to the outer edge of the effective pixel region 60 is disposed at each of positions facing the sides parallel to the row direction and the sides parallel to the column direction of the pixels 8.
(7) Although the example in which the trench portion 22 is a penetrating trench portion has been described in the first embodiment, it is also possible to adopt other configurations. For example, the trench portion 22 may be a bottomed trench portion that includes an opening in the rear surface S1 of the semiconductor substrate 12 and has a bottom portion inside of the semiconductor substrate 12 as illustrated in Fig. 22, for example. In this case, a p-type semiconductor region (hereinafter, also referred to as a "p-type layer 36") is formed on the side of the front surface S2 from the side of the front surface S2 of the semiconductor substrate 12, the p-type semiconductor region (first conductivity-type region 19) is then further formed in the inner wall surface and the bottom surface of the trench portion 22 from the side of the rear surface S1 of the semiconductor substrate 12, and the first conductivity-type region 19 is connected to the p-type layer 36 using plasma doping, ion implanting injection method, and the like. In this manner, the p-type layer 36 and the first conductivity-type region 19 can configure the hole accumulation region 23 where holes are accumulated. Therefore, the hole accumulation region 23 is continuously formed from the rear surface S1 to the front surface S2 of the semiconductor substrate 12.

### <2. Second embodiment>

### [2-1 Configurations of main components]

Next, a solid-state imaging device 1 according to a second embodiment of the present disclosure will be described. Since an overall configuration of the solid-state imaging device 1 according to the second embodiment is similar to that in Fig. 1, illustration thereof is omitted. Fig. 23 is a diagram corresponding to Fig. 3 in the first embodiment and illustrating a sectional configuration of the solid-state imaging device 1 according to the second embodiment taken at a position corresponding to the line H-H in Fig. 24. Fig. 24 is a view corresponding to Fig. 4 in the first embodiment and illustrating a positional relationship in a planar configuration between a semiconductor substrate 12 and a connecting portion 73 (which will be described later) in a view in a thickness direction of the semiconductor substrate 12. Fig. 24 illustrates a sectional configuration of the connecting portion 73 and the like taken at the position of a rear surface S1 of the semiconductor substrate 12. Similarly, Figs. 30 to 34, and Figs. 36 to 40, which will be described later, are also diagrams illustrating a sectional configuration of the connecting portion 73 and the like taken at the position of the rear surface S1 of the semiconductor substrate 12. In Figs. 23 and 24, parts corresponding to those in Figs. 3 and 4 will be denoted by the same reference signs, and repeated description will be omitted.

The solid-state imaging device 1 according to the second embodiment is different from the solid-state imaging device 1 according to the first embodiment in that a frame-shaped contact 24 and a barrier metal layer 25 (hereinafter, also referred to as a "connecting portion 73") are disposed in a two-dimensional array while being divided into a plurality of divided pieces 73a as illustrated in Figs. 23 and 24. In the second embodiment, the contact 24 and the barrier metal layer 25 just below the contact 24 configure the "connecting portion" unlike other embodiments.

In the second embodiment, the connecting portion 73 is formed between the rear surface S1 of the semiconductor substrate 12 in the light shielding pixel region 71 and a light shielding film 14. Fig. 23 illustrates an exemplary case in which the connecting portion 73 is formed by causing a part of the light shielding film 14 and the barrier metal layer 25 to project in a U-shaped groove on the side of the semiconductor substrate 12. As illustrated in Fig. 24, the connecting portion 73 is disposed by being divided into a plurality of divided pieces 73a to avoid a region where a trench portion 22 is formed on the rear surface S1 of the semiconductor substrate 12 in a view in the thickness direction of the semiconductor substrate 12. In other words, the divided pieces 73a are disposed in a region overlapping a photoelectric conversion unit PD (including a first conductivity-type region 19) of each pixel 8. The connecting portion 73 is divided such that one divided piece 73a is disposed for one pixel 8. In this manner, each side of the frame-shaped connecting portion 73 is configured of the divided pieces 73a disposed in a two-dimensional array. The outer shape of the divided pieces 73a is a rectangular shape in a view in the thickness direction of the semiconductor substrate 12.

As illustrated in Fig. 23, each divided piece 73a penetrates through the insulating film 13 to be electrically connected to a first conductivity-type region 19 (hole accumulation region 23) of the semiconductor substrate 12. At the position where the divided piece 73a is formed, a through-hole 74 is formed in the insulating film 13, and the first conductivity-type region 19 is exposed. The through-hole 73 penetrates through the insulating film 13 and has a bottom portion in a semiconductor substrate 12. Fig. 23 illustrates an exemplary case in which the divided piece 73a is connected to a part of the first conductivity-type region 19 on the side of a front surface S2 and the first conductivity-type region 19 is connected to a potential supply source of a ground potential Vss via a contact 21 and a wiring 26 in a wiring layer 18. In this manner, the divided piece 73a (connecting portion 73) causes a light shielding film 14 to be electrically connected to the first conductivity-type region 19 and causes the light shielding film 14 to be connected to the potential supply source of the ground potential Vss via the first conductivity-type region 19, the contact 21, and the wiring 26 in the wiring layer 18.
In the second embodiment, the insulating film 13 functions as a protective film covering a rear surface S1 of the semiconductor substrate 12. Examples of the protective film include a film that inhibits passage of at least either gas (gaseous matters, hydrogen, and the like) or liquid (moisture and the like). As a material of the protective film, it is possible to adopt silicon oxide (SiO), silicon nitride (SiN), or carbon-containing silicon oxide film (SiOC).

As described above, the solid-state imaging device 1 according to the second embodiment is configured such that the light shielding film 14 is electrically connected to a hole accumulation region 23 via the connecting portion 73. It is thus possible to prevent arcing from occurring in the light shielding film 14 in a manufacturing process, for example. Therefore, it is possible to curb breakage, defects, and the like of the light shielding film 14 and to obtain an image with satisfactory image quality.
Here, in a case where a configuration in which the connecting portion 73 is not divided is adopted as illustrated in Fig. 25, for example, gas inside of the trench portion 22 may be discharged to the outside through the through-hole 74 in the insulating film 13, or gas or moisture may enter the trench portion 22 from the outside. Therefore, the light shielding film 14 may be degraded, which may affect a pixel region 2 and cause property fluctuation.
On the other hand, the second embodiment adopts the configuration (array-like arrangement) in which the connecting portion 73 is divided into the plurality of divided pieces 73a and is disposed to avoid a region where the trench portion 22 is formed on the rear surface S1 of the semiconductor substrate 12 in a view in the thickness direction of the semiconductor substrate 12 as illustrated in Fig. 24. Therefore, it is possible to block the opening of the trench portion 22 by covering it with the insulating film 13 (protective film), to prevent gas inside of the trench portion 22 from being discharged to the outside, and to prevent gas and moisture from entering the trench portion 22 from the outside. It is thus possible to prevent degradation of the light shielding film 14 and to prevent influences on a pixel region 2 and occurrence of property fluctuation. Furthermore, a small amount of decrease in area of the connecting portion 73 is required and a sufficient antenna ratio can be secured by adopting the above configuration (array-like arrangement) as a configuration of the connecting portion 73.

### [2-2 Method of manufacturing solid-state imaging device]

Next, a method of manufacturing the solid-state imaging device 1 according to the second embodiment will be described.

First, processing up to a Cu-Cu junction between the wiring layer 18 and a logic substrate 33 is performed as illustrated in Fig. 11 by following the procedure illustrated in Figs. 7 to 11. Note that although illustration is omitted in Fig. 11, a contact 21 illustrated in Fig. 23 is also formed in a case where the contact 21 illustrated in Fig. 23 is used to supply the ground potential Vss (GND) to the first conductivity-type region 19. Subsequently, polysilicon 30 is removed from the inside of the trench portion 22, and the insulating film 13 is then continuously formed inside of the trench portion 22 and on the rear surface S1 of the semiconductor substrate 12 as illustrated in Fig. 26. Then, a mask 75 having an opening at a position where the through-hole 74 (see Fig. 23) is formed is formed in a rear surface S3 of the insulating film 13 in a light shielding pixel region 71. As the mask 75, it is possible to adopt a resist mask or a hard mask, for example.

Subsequently, the through-hole 74 penetrating through the insulating film 13 is formed as illustrated in Fig. 27 by using a dry etching method or a wet etching method. In this manner, the first conductivity-type region 19 is exposed in a bottom surface S9 of the through-hole 74. Subsequently, the mask 75 is peeled off from the rear surface S3 of the insulating film 13 as illustrated in Fig. 28. Then, a barrier metal layer 25 and the light shielding film 14 are continuously formed on the rear surface S3 of the insulating film 13 and inside of the through-hole 74, thereby forming the divided pieces 73a (connecting portion 73) by the barrier metal layer 25 and the light shielding film 14 inside of the through-hole 74 as illustrated in Fig. 29. In this manner, the light shielding film 14 is electrically connected to the ground potential Vss via the connecting portion 73 and the first conductivity-type region 19 (hole accumulation region 23). It is thus possible to prevent arcing from occurring in the light shielding film 14 due to sputtering or the like in the later process. Subsequently, various configurations (a flattening film, a color filter, an on-chip lens, and the like) on the side of the rear surface S4 of the light shielding film 14 are formed.
The solid-state imaging device 1 illustrated in Fig. 23 is manufactured through such a procedure.

### [2-3 Modification examples]

(1) Note that although the example in which one photoelectric conversion unit PD is formed for one pixel 8 has been described in the second embodiment, it is also possible to adopt other configurations. For example, the semiconductor substrate 12 may be configured such that two photoelectric conversion units PD₁ and PD₂ are formed for one pixel 8 as illustrated in Figs. 30 and 31. In other words, a configuration similar to that in Fig. 17 may be adopted. In this manner, it is possible to detect a phase difference from outputs of the two photoelectric conversion units PD₁ and PD₂. In this case, a part of the trench portion 22 located between the two photoelectric conversion units PD₁ and PD₂ is configured to be disconnected on the center side of the pixel 8 in a view in the thickness direction of the semiconductor substrate 12. Also, the disconnected location is caused to function as an overflow path that allows a charge to pass from one side to the other side between the adjacent photoelectric conversion units PD₁ and PD₂ by forming an impurity layer in which p-type impurities are doped. Fig. 30 illustrates an exemplary case where the connecting portion 73 is divided such that one divided piece 73a is disposed for one pixel 8. Specifically, a polygonal shape (an H shape, for example) with a contour following the shape of the inner wall surface of the trench portion 22 is adopted as the outer shape of the divided pieces 73a in a view in the thickness direction of the semiconductor substrate 12. Fig. 31 illustrates an exemplary case in which the connecting portion 73 is divided such that two or more divided pieces 73a are disposed for one pixel 8. Specifically, the connecting portion 73 at the position of the impurity layer functioning as an overflow path is omitted, and two rectangular shapes formed to be spaced apart from each other in a view in the thickness direction of the semiconductor substrate 12 are adopted as the outer shape of the divided pieces 73a. It is thus possible to simplify the shape of the divided pieces 73a and to facilitate formation of the connecting portion 73. Note that although Figs. 30 and 31 illustrate the example in which the photoelectric conversion units PD₁ and PD₂ are disposed to be aligned in the row direction, the photoelectric conversion units PD₁ and PD₂ may be disposed to be aligned in the column direction or may be disposed to be aligned in an oblique direction.
(2) A configuration in which a plurality of shared-type on-chip lenses 76 formed for each block of four photoelectric conversion units PD₁, PD₂, PD₃, and PD₄ arranged in a 2 × 2 array shape are included as illustrated in Figs. 32 and 33, for example, may be adopted. In this case, the color filter is also formed to be a shared type for each block. It is possible to acquire a phase difference signal from pixel signals of the four photoelectric conversion units PD by adopting the on-chip lenses 76 and the color filter of the shared type. In this case, a part of the trench portion 22 located between the four photoelectric conversion units PD₁ to PD₄ is configured to be disconnected on the center side of the pixel 8 in a view in the thickness direction of the semiconductor substrate 12. Also, the disconnected location is caused to function as an overflow path that allows a charge to pass from one side to the other side between the adjacent photoelectric conversion units PD₁ to PD₄ by forming the impurity layer in which p-type impurities are doped. Fig. 32 illustrates an exemplary case in which the connecting portion 73 is divided such that one divided piece 73a is disposed for four photoelectric conversion units PD₁ to PD₄ (four pixels 8). Specifically, a polygonal shape (an X shape, for example) with a contour following the shape of the inner wall surface of the trench portion 22 is adopted as the outer shape of the divided pieces 73a in a view in the thickness direction of the semiconductor substrate 12. Also, Fig. 33 illustrates an exemplary case in which the connecting portion 73 is divided such that two or more divided pieces 73a are disposed for four photoelectric conversion units PD₁ to PD₄ (four pixels 8). Specifically, the connecting portion 73 at the position of the impurity layer functioning as an overflow path is omitted, and four rectangular shapes formed to be spaced apart from each other in a view in the thickness direction of the semiconductor substrate 12 are adopted as the outer shape of the divided pieces 73a. It is thus possible to simplify the shape of the divided pieces 73a and to facilitate formation of the connecting portion 73.
(3) Although the example in which the divided pieces 73a are disposed in a two-dimensional array to avoid only the region where the trench portion 22 is formed has been described in the second embodiment, it is also possible to adopt other configurations. For example, a configuration in which the connecting portion 73 is disposed by being divided into the plurality of divided pieces 73a to avoid a part of a region where the trench portion 22 is not formed as well as the region where the trench portion 22 is formed in the rear surface S1 in a view in the thickness direction of the semiconductor substrate 12 may be adopted as illustrated in Fig. 34. Fig. 34 illustrates an exemplary case where the divided pieces 73a are disposed in a staggered shape at intervals corresponding to one pixel 8 in each of the row direction and the column direction to avoid the region where the trench portion 22 is formed and some of the pixels 8 (photoelectric conversion units PD). It is thus possible to increase the area of the insulating film 13 (protective film) covering the opening of the trench portion 22 and to more reliably prevent entrance and exiting of gas and moisture through the opening of the trench portion 22. Note that although Fig. 34 illustrates an example in which the divided pieces 73a are disposed in a staggered shape, other arrangement may be adopted as long as it is possible to secure a necessary antenna ratio with the arrangement. Also, the configuration in which some of the pixels 8 (photoelectric conversion units PD) are avoided such as the staggered arrangement illustrated in this modification example can also be applied to the configuration in which two photoelectric conversion units PD₁ and PD₂ are formed for one pixel 8 as illustrated in Figs. 30 and 31 and the configuration in which four photoelectric conversion units PD₁ to PD₄ form one block as illustrated in Figs. 32 and 33.
(4) Although the example in which the connecting portion 73 is in a direct contact with the first conductivity-type region 19 has been described in the second embodiment, it is also possible to adopt other configurations. For example, a configuration in which the connecting portion 73 is not in a direct contact with the first conductivity-type region 19 as illustrated in Figs. 35 and 36 may be adopted. In this case, a p-type semiconductor region 77 electrically connected to the first conductivity-type region 19 is formed on the rear surface S1 of the semiconductor substrate 12. As a method of forming the p-type semiconductor region 77, it is possible to adopt a method of introducing p-type impurities from the rear surface S1 of the semiconductor substrate 12 by using an ion implanting injection method, for example. Also, the connecting portion 73 (divided pieces 73a) is configured to be in contact with the p-type semiconductor region 77 and to be electrically connected to the first conductivity-type region 19 via the p-type semiconductor region 77. Thus, there is no need to form the divided pieces 73a up to a location near the first conductivity-type region 19 (that is, a location near the inner wall surface of the trench portion 22), and it is possible to reduce the area of the divided pieces 73a. Therefore, it is possible to increase the area of the insulating film 13 (protective film) covering the opening of the trench portion 22 and to more reliably prevent entrance and exiting of gas and moisture through the opening of the trench portion 22. Fig. 36 is a diagram illustrating a positional relationship in a planar configuration between the semiconductor substrate 12 and the connecting portion 73 in a view in the thickness direction of the semiconductor substrate 12.
(5) Although the example in which the connecting portion 73 is divided such that one divided piece 73a is disposed for one pixel 8 has been described in the second embodiment, it is also possible to adopt other configurations. For example, the connecting portion 73 may be configured to be divided such that two or more divided pieces 73a are disposed for one pixel 8 as illustrated in Figs. 37 and 38. Fig. 37 illustrates an exemplary case in which the connecting portion 73 is divided such that two divided pieces 73a are disposed for one pixel 8, and Fig. 38 illustrates an exemplary case in which four divided pieces 73a are disposed for one pixel 8. Note that although Figs. 37 and 38 illustrate an example in which the shape of the divided pieces 73a is a rectangular shape, the divided pieces 73a may have another shape.
(6) Although the example in which the shape of the connecting portion 73 is a rectangular shape has been described in the second embodiment, it is also possible to adopt other configurations. For example, an arbitrary shape such as a round shape or a rounded square shape may be adopted as the shape of the connecting portion 73 as illustrated in Figs. 39 and 40. Fig. 39 illustrates an exemplary case in which the shape of the connecting portion 73 is a round shape, and Fig. 40 illustrates an exemplary case in which a rounded square shape is adopted.
(7) Although the example in which the trench portion 22 is formed as a trench portion penetrating through the semiconductor substrate 12 from the rear surface S1 to the front surface S2 has been described in the second embodiment, it is also possible to adopt other configurations. As illustrated in Fig. 41, for example, the trench portion 22 may be formed as a trench portion that is formed from the rear surface S1 to a midway position between the rear surface S1 and the front surface S2, that is, a non-penetrating trench portion. In this case, the first conductivity-type region 19 is continuously formed entirely on the side of the inner wall surface of the trench portion 29, entirely on the side of the front surface S2 of the semiconductor substrate 12, and in the region therebetween (the region from the bottom surface of the trench portion 29 to the front surface S2 of the semiconductor substrate 12). As a method of forming the first conductivity-type region 19 (hole accumulation region 23), it is possible to adopt a method of introducing p-type impurities from the rear surface S1 of the semiconductor substrate 12 by using an ion implanting injection method, for example.

### <3. Third embodiment>

### [3-1 Configurations of main components]

Next, a solid-state imaging device 1 according to a third embodiment of the present disclosure will be described. An overall configuration of the solid-state imaging device 1 according to the third embodiment is similar to that in Fig. 1, and illustration thereof will thus be omitted. Fig. 42 is a diagram illustrating a sectional configuration of the solid-state imaging device 1 according to the third embodiment taken along the line D-D in Fig. 43. In Fig. 42, parts corresponding to those in Fig. 3 will be denoted by the same reference signs, and repeated description will be omitted.

The solid-state imaging device 1 according to the third embodiment is different from the solid-state imaging device 1 according to the first embodiment in that a conductor 37 is embedded in a trench portion 22 instead of the insulating film 13 and a contact 24 is electrically connected to the conductor 37 as illustrated in Fig. 42.

In the third embodiment, a part formed in an effective pixel region 60 and a part formed in a light shielding pixel region 71 of the trench portion 22 are physically disconnected by a peripheral edge portion of the effective pixel region 60 as illustrated in Figs. 43 and 44. An n-type semiconductor region is formed in the region (hereinafter, also referred to as a "disconnected region 38") disconnecting the trench portion 22. Fig. 43 is a diagram illustrating a positional relationship in a planar configuration between the semiconductor substrate 12 and the contact 24 in a view in the thickness direction of the semiconductor substrate 12. In Fig. 43, layers such as the light shielding film 14 and the barrier metal layer 25 are omitted similarly to Fig. 4 to make the positional relationship therebetween clear. Fig. 44 is a diagram illustrating a sectional configuration of the solid-state imaging device 1 taken along the line E-E in Fig. 43.

The conductor 37 is embedded in the trench portion 22 as illustrated in Figs. 42, 43, and 44. The conductor 37 is continuously formed from a rear surface S1 to a front surface S2 of the semiconductor substrate 12. As a material of the conductor 37, it is possible to adopt doped polysilicon or an indium tin oxide (ITO) electrode, for example. As illustrated in Fig. 44, the conductor 37 (hereinafter, also referred to as a "first conductor 37a") located at a part (hereinafter, also referred to as a "first trench portion 22a") of the trench portion 22 formed inside of the effective pixel region 60 is electrically connected to a supply source (not illustrated) of a negative bias voltage (hereinafter, also referred to as a "negative bias"), and a negative bias is applied thereto. In this manner, it is possible to bring the part of the trench portion 22 on the side of the side of the inner wall surface into a high hole concentration state and to curb generation of a dark current in the effective pixel region 60. Fig. 44 illustrates an exemplary case in which a contact 39 (for example, a contact of p-type doped polysilicon) formed at a part of the first conductor 37a on the side of the front surface S2 and a penetrating electrode 40 (a contact of tungsten (W) or doped polysilicon, for example) formed at a position of the contact 39 facing the front surface S2 are connected to the first conductor 37a and the first conductor 37a is connected to a supply source of a negative bias via the contact 39 and the penetrating electrode 40.

Also, the conductor 37 (hereinafter, also referred to as a "second conductor 37b") located at a part (hereinafter, also referred to as a "second trench portion 22b") of the trench portion 22 formed in the light shielding pixel region 71 is electrically connected to a supply source of a ground potential Vss (GND). Fig. 44 illustrates an exemplary case in which a contact 41 (for example, a contact of p-type doped polysilicon) formed at a part of the second conductor 37b on the side of the front surface S2 and a penetrating electrode 42 (for example, contact of tungsten (W) or doped polysilicon) formed at a position of the contact 41 facing the front surface S2 are connected to the second conductor 37b and the second conductor 37b is connected to the supply source of the ground potential Vss via the contact 41 and the penetrating electrode 42. Here, if the first conductor 37a and the second conductor 37b are electrically connected, for example, then short-circuiting in which a large current flows with GND to the negative bias may occur. On the other hand, since the third embodiment adopts the configuration in which the trench portion 22 is physically disconnected, it is possible to electrically disconnect the first conductor 37a and the second conductor 37b and to prevent occurrence of short circuiting.
Also, the contact 24 is electrically connected to the second conductor 37b via a barrier metal layer 25 as illustrated in Fig. 44. In this manner, the contact 24 causes the light shielding film 14 to be electrically connected to the second conductor 37b and causes the light shielding film 14 to be connected to the potential supply source of the ground potential Vss via the second conductor 37b, the contact 41, and the penetrating electrode 42. It is thus possible to prevent arcing from occurring in the light shielding film 14 through sputtering or the like in a manufacturing process, for example.

### [3-2 Modification examples]

(1) Note that although the example in which the trench portion 22 is physically disconnected in order to prevent electrical connection between the first conductor 37a and the second conductor 37b has been described in the third embodiment, it is also possible to adopt other configurations. For example, a configuration in which a part (first conductor 37a) in the trench portion 22 formed in the effective pixel region 60 and a part (second conductor 37b) in the trench portion 22 formed in the light shielding pixel region 71 of the conductor 37 are electrically disconnected by the peripheral edge portion of the effective pixel region 60 as illustrated in Figs. 45 and 46 may be adopted. It is possible to prevent short-circuiting in which a large current flows with GND-negative bias via the first conductor 37a and the second conductor 37b through the electrical disconnection. Figs. 45 and 46 illustrate an exemplary case in which the insulating film 13 is embedded in a region 43 between the first conductor 37a and the second conductor 37b in the trench portion 22. Fig. 46 is a diagram illustrating a sectional configuration of the solid-state imaging device 1 taken along the line F-F in Fig. 45.
(2) The solid-state imaging device 1 according to the third embodiment can also adopt the various configurations described in the second to sixth modification examples of the first embodiment.

### <4. Fourth embodiment>

### [4-1 Configuration of main components]

Next, a solid-state imaging device 1 according to a fourth embodiment of the present disclosure will be described. An overall configuration of the solid-state imaging device 1 according to the fourth embodiment is similar to that in Fig. 1, and illustration thereof will thus be omitted. Fig. 47 is a diagram illustrating a planar configuration at one of four corners of a pixel region 2 according to the fourth embodiment. Fig. 48 is a diagram illustrating a sectional configuration of the solid-state imaging device 1 taken along the line G-G in Fig. 47. In Figs. 47 and 48, parts corresponding to those in Figs. 2 and 3 will be denoted by the same reference signs, and repeated description will be omitted. Note that although nothing is illustrated on the side of a rear surface S4 of a light shielding film 14 in Fig. 48, a flattening film, a color filter, an on-chip lens, and the like may be formed.

The solid-state imaging device 1 according to the fourth embodiment is different from the solid-state imaging device 1 according to the first embodiment in that a contact 24 (a "connecting portion" in a broad sense) is disposed by being divided like a dashed line in a view in the thickness direction of a semiconductor substrate 12 as illustrated in Fig. 47.

In the fourth embodiment, the light shielding film 14 is disposed on the side of a rear surface S3 of an insulating film 13 and covers up to a region (hereinafter, also referred to as an "outer region 72") on the side further outward than the light shielding pixel region 71 as illustrated in Figs. 47 and 48. Specifically, the light shielding film 14 is formed in a grid shape with each photoelectric conversion unit PD on the side of the rear surface S1 opened and shields light in a region between the photoelectric conversion units PD in an effective pixel region 60 in a semiconductor substrate 12. In a region (a region including the light shielding pixel region 71 and the outer region 72; hereinafter, also referred to as a "peripheral region 70") surrounding the effective pixel region 60, the light shielding film 14 has no openings corresponding to the photoelectric conversion units PD and shields light in the entire peripheral region 70. As a material of the light shielding film 14, it is possible to adopt tungsten (W), aluminum (Al), or copper (Cu), for example.

Furthermore, a fixed charge film 35 having a negative charge is disposed to continuously cover the entire inner wall surface of the trench portion 22 and the entire rear surface S1 of the semiconductor substrate 12 between the inner wall surface and the insulating film 13 and between the rear surface S1 and the insulating film 13 as illustrated in Fig. 48. With the fixed charge film 35, it is possible to bring a part (hereinafter, also referred to as an "inner wall surface-side part 28") of the semiconductor substrate 12 on the side of the inner wall surface of the trench portion 22 into a high hole concentration state and to curb generation of a dark current. As a material of the fixed charge film 35, it is possible to adopt a high refractive index material film or a high dielectric film having a negative charge and capable of generating a fixed charge and enhancing pinning by forming the fixed charge film 35 on the semiconductor substrate 12. Examples thereof include oxide or nitride containing at least one elements from hafnium (Hf), aluminum (Al), zirconium (Zr), tantalum (Ta), and titanium (Ti). Fig. 48 illustrates an exemplary case in which the fixed charge film 35 is formed as a two-layer structure of alumina (Al₂O₃) and tantalum oxide film (Ta₂O₅). Also, the insulating film 13 is continuously disposed in the space inside of the trench portion 22 and on a rear surface S7 of the fixed charge film 35. These two films, namely the fixed charge film 35 and the insulating film 13 configure a hydrogen barrier film 44 (a film that inhibits passage of hydrogen 50 (see Figs. 56, 57, and the like) between the semiconductor substrate 12 and the light shielding film 14.

Furthermore, the contact 24 is formed between the rear surface S1 of the outer region 72 and the light shielding film 14 as illustrated in Fig. 48. Fig. 48 illustrates an exemplary case in which the contact 24 is formed by causing a part of the light shielding film 14 to project in a U-shaped groove on the side of the semiconductor substrate 12. As illustrated in Fig. 49, the contact 24 is disposed by being divided like a dashed line to surround the periphery of the effective pixel region 60 in a view in the thickness direction of the semiconductor substrate 12 (hereinafter, also referred to as a "dashed-line arrangement"). In other words, a range that the contact 24 occupies in a circumferential direction F surrounding the effective pixel region 60 is only a part of the entire periphery in the circumferential direction F in a view in the thickness direction of the semiconductor substrate 12. Fig. 49 illustrates, as a dashed line-line disposition, an exemplary case in which a column of components (hereinafter, also referred to as "divided contacts 24a") of the contact 24 aligned in parallel to the column direction of pixels 8 and a column of the divided contacts 24a aligned in parallel to the row direction of the pixels 8 are disposed to configure sides of a quadrangle surrounding the periphery of the light shielding pixel region 71, which is a region on the side further outward than the effective pixel region 60 and the columns are spaced apart from each other at corners of the quadrangle. It is possible to exclude the corners from the contact 24 and to avoid an increase in line width of the contact 24 at the corners by the columns being spaced apart from each other at the corners. Therefore, it is possible to keep the depth of a groove 34 (see Fig. 56) with a shape corresponding to the contact 24 constant at each part of the groove 34 when the groove 34 is formed in the light shielding film 14 and the semiconductor substrate 12 in a process of forming the contact 24 and to avoid deepening of the groove 34 at the corners. Therefore, it is possible to curb working damage on the trench portion 22 and to curb degradation of dark current properties. Each column of the divided contacts 24a is formed by the plurality of divided contacts 24a with the same length, the same width, and the same thickness being disposed at constant intervals in the length direction.

As illustrated in Fig. 48, the contact 24 (divided contacts 24a) penetrates through the hydrogen barrier film 44 (the insulating film 13 and the fixed charge film 35) and is electrically connected to a ground region 46 in the semiconductor substrate 12 via a barrier metal layer 25. A through-hole 45 is formed in the hydrogen barrier film 44 at a position where each divided contact 24a is formed. As the ground region 46, it is possible to adopt a p-type semiconductor region (hereinafter, also referred to as a "p-well region"), for example. The ground region 46 is continuously formed from the rear surface S1 to the front surface S2 of the semiconductor substrate 12 at a position overlapping the contact 24 in the outer region 72 in a view in the thickness direction of the semiconductor substrate 12. Also, the ground region 46 is electrically connected to the ground potential Vss (GND). Fig. 48 illustrates an exemplary case where a contact 47 is connected to a part of the ground region 46 on the side of the front surface S2 and the ground region 46 is connected to the potential supply source (not illustrated) of the ground potential Vss via the contact 47 and a wiring 26 in the wiring layer 18. In this manner, the contact 24 causes the light shielding film 14 to be electrically connected to the ground region 46 and causes the light shielding film 14 to be connected to the potential supply source of the ground potential Vss via the ground region 46, the contact 47, and the wiring 26 in the wiring layer 18. Moreover, it is possible to prevent metal atoms in the insulating film 13 from spreading to inside of the semiconductor substrate 12 by sandwiching the barrier metal layer 25 between the contact 24 and the ground region 46 (semiconductor substrate 12). As a material of the barrier metal layer 25, it is possible to adopt titanium (Ti) or titanium nitride (TiN), for example.

As described above, the solid-state imaging device 1 according to the fourth embodiment is configured such that the light shielding film 14 is electrically connected to the ground region 46 via the contact 24. It is thus possible to prevent arcing from occurring in the light shielding film 14 in the manufacturing process, for example. Therefore, it is possible to curb breakage, defects, and the like of the light shielding film 14 and to obtain an image with more satisfactory image quality.
Here, the through-hole 45 is formed in the hydrogen barrier film 44 at the position where the contact 24 is formed as described above. Also, the barrier metal layer 25 is disposed between the contact 24 and the ground region 46. Therefore, if annealing is performed after formation of the contact 24, the hydrogen 50 (see Figs. 56, 57, and the like) included in the semiconductor substrate 12 is discharged to the outside through the through-hole 45 and is then occluded into titanium (Ti) or titanium nitride (Ti) in the barrier metal layer 25. Therefore, the concentration of the hydrogen 50 decreases toward the side of the contact 24 and a hydrogen concentration gradient in accordance with the distance from the contact 24 occurs in the semiconductor substrate 12. Therefore, the opening area of the through-hole 45 may increase and the hydrogen concentration gradient may increase in a case where the contact 24 has a configuration (a configuration in a comparative example) continuously surrounding the periphery of the light shielding pixel region 71 as illustrated in Fig. 50, for example. As a result, hydrogen termination may be inhibited near the through-hole 45 of the semiconductor substrate 12, and a dark current may increase. Also, in deactivation of an acceptor such as boron by hydrogen atoms may be curbed near the through-hole 45 in the semiconductor substrate 12. Therefore, a dark current difference may be generated near the through-hole 45, and a dark current differential (frame variations) may be generated as illustrated in Fig. 51. As a result, image quality degradation may occur in a captured image due to such a dark current differential (frame variations). Fig. 51 is a diagram illustrating a captured image obtained on the basis of a charge of the photoelectric conversion units PD in the effective pixel region 60 and the light shielding pixel region 71 in a state where light incident on the effective pixel region 60 is blocked in a case where the configuration in the comparative example is adopted. Fig. 51 illustrates an exemplary case in which the dark current differential (frame variations) are generated on the side slightly closer to the center than the position where the through-hole 45 (contact 24) is formed.

On the other hand, the contact 24 has a configuration (dashed line-like arrangement) in which the contact 24 is disposed by being divided like a dashed line to surround the periphery of the light shielding pixel region 71 which is the region on the side further outward than the effective pixel region 60 in a view in the thickness direction of the semiconductor substrate 12 as illustrated in Fig. 49 in the fourth embodiment. In other words, the configuration in which the range that the contact 24 occupies in the circumferential direction F surrounding the effective pixel region 60 is only a part of the entire periphery in the circumferential direction F in a view in the thickness direction of the semiconductor substrate 12 is adopted. Therefore, it is possible to reduce the opening area of the through-hole 45, to curb a decrease in concentration of the hydrogen 50 near the through-hole 45, and to reduce a hydrogen concentration gradient. Therefore, it is possible to curb a dark current difference near the through-hole 45 due to the hydrogen concentration gradient and to curb property fluctuations of the dark current as illustrated in Fig. 52. As a result, it is possible to curb image quality degradation of the captured image and to improve image quality of the captured image by curbing such a dark current differential (frame variations). Therefore, it is possible to cause the contact 24 for connecting the light shielding film 14 to the ground potential to have a more appropriate configuration. Fig. 52 is a diagram illustrating a captured image obtained from a charge of the photoelectric conversion units PD in the effective pixel region 60 and the light shielding pixel region 71 in a state where light incident on the effective pixel region 60 is blocked in a case where the configuration in the fourth embodiment is adopted.

### [4-2 Method of manufacturing solid-state imaging device]

Next, a method of manufacturing the solid-state imaging device 1 according to the fourth embodiment will be described.

First, as illustrated in Fig. 53, the trench portion 22 is formed in the semiconductor substrate 12, the first conductivity-type region 19 (p-type semiconductor region) is formed in the inner wall of the trench portion 22, and the polysilicon 30 is embedded in the space inside of the trench portion 22. Subsequently, an oxide film 49 is embedded in the trench portion 22 on the side of the front surface S2, the upper and lower sides of the semiconductor substrate 12 are reversed, and polishing such as CMP is then performed on the side of the rear surface S1 of the semiconductor substrate 12. Then, the polysilicon 30 is removed from the inside of the trench portion 22 as illustrated in Fig. 54. Then, the fixed charge film 35 (for example, alumina (AO) or tantalum oxide (PT)) and a thin silicon oxide film 48 (for example, an LTO film) functioning as a hydrogen supply source in hydrogen termination processing are formed in this order inside of the trench portion 22 and on the rear surface S1 of the semiconductor substrate 12 as illustrated in Fig. 55. Subsequently, the semiconductor substrate 12 is annealed, the hydrogen 50 is caused to spread in the semiconductor substrate 12 from the silicon oxide film 48, and hydrogen termination processing is performed on the semiconductor substrate 12. Here, if annealing is performed, then the hydrogen 50 is discharged from the side of the rear surface S1 of the semiconductor substrate 12 to the atmosphere through the fixed charge film 35 and the silicon oxide film 48 as illustrated by the arrow H in Fig. 55 due to the thin silicon oxide film 48. However, since the amount of hydrogen 50 discharged is similar at each part of the rear surface S1, and no concentration gradient of the hydrogen 50 is formed in the semiconductor substrate 12.

Subsequently, the insulating film 13 is formed inside of the trench portion 22 and on the rear surface S1 of the semiconductor substrate 12, the hydrogen barrier film 44 including the insulating film 13 and the fixed charge film 35 is formed, and the bottomed groove 34 penetrating through the hydrogen barrier film 44 (the insulating film 13 and the fixed charge film 35) is then formed at the position where each of the divided contacts 24a is scheduled to be formed in the semiconductor substrate 12 as illustrated in Fig. 56. In this manner, the through-hole 45 is formed in the hydrogen barrier film 44 (the insulating film 13 and the fixed charge film 35, and the rear surface S1 of the ground region 46 in the semiconductor substrate 12 is exposed in the bottom surface S8 of the groove 34. Then, the barrier metal layer 25 and the divided contacts 24a are formed in this order in the groove 34 as illustrated in Fig. 57, and the light shielding film 14 is formed on the rear surface S3 of the insulating film 13. In this manner, the light shielding film 14 is electrically connected to the ground potential Vss (GND) via the contact 24 and the ground region 46. Therefore, it is possible to prevent arcing (abnormal discharge) from occurring in the light shielding film 14 in the manufacturing process. Here, if annealing is performed after the divided contacts 24a (contact 24) are formed as described above, the hydrogen 50 included in the semiconductor substrate 12 is discharged to the outside through the through-hole 45 as illustrated by the arrow I in Fig. 57 and is then occluded in titanium (Ti) or titanium nitride (Ti) in the barrier metal layer 25. On the other hand, the contact 24 is divided (divided contacts 24a) like a dashed line in the first embodiment, it is thus possible to reduce the hydrogen concentration gradient near the contact 24 and to curb occurrence of a dark current differential (frame fluctuation). Then, various configurations (for example, a flattening film, a color filter, an on-chip lens, and the like) on the side of the rear surface S4 of the light shielding film 14 are formed.

The solid-state imaging device 1 illustrated in Fig. 48 is manufactured through such a procedure.

### [4-3 Modification examples]

(1) Note that the example in which the contact 24 is formed between the rear surface S1 in the outer region 72 and the light shielding film 14 has been described in the fourth embodiment, the present invention is not limited thereto. For example, a configuration in which the contact 24 is formed between the rear surface S1 in the light shielding pixel region 71 and the light shielding film 14 may also be adopted similarly to the contact 24 in the first embodiment. In other words, it is only necessary for the position where the contact 24 is formed to be between the rear surface S1 in the peripheral region 70, which is a region including the outer region 72 and the light shielding pixel region 71, and the light shielding film 14.
(2) Although the example (dashed line-like arrangement) in which the contact 24 is disposed by being divided like a dashed line to surround the periphery of the effective pixel region 60 is illustrated in the fourth embodiment, the present invention is not limited thereto. For example, the contact 24 may be configured to be disposed by being divided like a dashed line at each of positions in the peripheral region 70 facing two mutually parallel sides of the outer edge of the effective pixel region 60 in a view in the thickness direction of the semiconductor substrate 12 as illustrated in Figs. 58 and 59. Fig. 58 illustrates an exemplary case in which a column of the divided contacts 24a aligned in parallel to the row direction is disposed at each of positions facing two sides (the upper side and the lower side of the light shielding pixel region 71 in Fig. 58) parallel to the row direction of the pixels 8 in the outer edge of the light shielding pixel region 71, which is a region on the side further outward than the effective pixel region 60. Also, Fig. 59 illustrates an exemplary case in which a column of the divided contacts 24a aligned in parallel to the column direction is disposed at each of positions facing two sides (the left side and the right side of the light shielding pixel region 71 in Fig. 59) parallel to the column direction of the pixels 8.
(3) A configuration in which the contact 24 is disposed at each of positions of the peripheral region 70 surrounding the four corners of the effective pixel region 60 in a view in the thickness direction of the semiconductor substrate 12 as illustrated in Fig. 60, for example, may be adopted. In this case, the contact 24 is configured to be divided such that a part along two sides sandwiching a vertex at each corner is divided at the part corresponding to the vertex. Fig. 60 illustrates an exemplary case in which two oblong divided contacts 24a forming an angle of 90° therebetween and separated at the part corresponding to the vertex are disposed at each corner to surround each corner of the light shielding pixel region 71, which is a region on the side further outward than the effective pixel region 60. For example, the contact 24 may be configured to be disposed at each of positions in the peripheral region 70 facing the vertexes at the four corners of the effective pixel region 60 in a view in the thickness direction of the semiconductor substrate 12 as illustrated in Fig. 61 may be adopted. In this case, the contact 24 is configured such that the longitudinal direction of the part facing the vertex at each corner is inclined with respect to each of two mutually perpendicularly intersecting directions of the outer edge of the effective pixel region 60. Fig. 61 illustrates an exemplary case in which one oblong divided contact 24a forming an angle of 45° with each of two mutually perpendicularly intersecting directions (the row direction and the column direction of the pixels 8) of the outer edge of the effective pixel region 60 is disposed at each of positions facing the vertex at each corner of the light shielding pixel region 71 which is a region on the side further outward than the effective pixel region 60. As illustrated in Fig. 62, for example, the contact 24 may be configured only of one divided contact 24a in the column of the divided contacts 24a illustrated in Fig. 49.
(4) The technology (for example, the technology disclosed in the first to fourth embodiments) according to the present disclosure can be generally applied to a light detection device including a range sensor for measuring the distance, which is also called a time of flight (ToF) sensor, and the like as well as the aforementioned solid-state imaging device 1 as an image sensor. The range sensor is a sensor that emits irradiated light toward an object, detects reflected light which returns when the irradiated light is reflected by a surface of the object, and calculates a distance to the object based on a time of flight from when the irradiated light is emitted to when the reflected light is received. As a ground structure of the light shielding film 14 in the range sensor, it is possible to adopt the structure of the aforementioned contact 24.

### <5. Fifth embodiment>

The technology according to the present disclosure (present technology) may be applied to various electronic devices.

Figs. 63 and 64 are diagrams illustrating examples of a schematic configuration of an imaging device (such as a digital still camera or a video camera) as an electronic device to which the present technology is applied.

An imaging device 1000 (digital still camera) illustrated in Fig. 63 includes a lens group 1001, a solid-state imaging device 1002 (the solid-state imaging device 1 according to the first embodiment), a signal processing circuit 1003, a memory 1004, and a monitor 1005. The signal processing circuit 1003, the memory 1004, and the monitor 1005 are connected to each other via a bus line 1006.

The lens group 1001 guides incident light (image light) from a subject to the solid-state imaging device 1002, and forms a light receiving surface (pixel region) of the solid-state imaging device 1002.
The solid-state imaging device 1002 includes a CMOS image sensor according to the above-described first embodiment. The solid-state imaging device 1002 converts a light amount of the incident light, an image of which has been formed on the light receiving surface by the lens group 1001, into an electrical signal in units of pixels and supplies the electrical signal as a pixel signal to the signal processing circuit 1003.
The signal processing circuit 1003 performs predetermined image processing on the pixel signal supplied from the solid-state imaging device 1002. Then, the signal processing circuit 1003 causes the memory 1004 to store an image signal after the image processing and causes the monitor 1005 to display the image of the subject on the basis of the image signal.
The memory 1004 is a flash memory or the like. The monitor 1005 is a display device such as a liquid crystal panel or an organic EL (Electro Luminescence) panel, for example.

An imaging device 2000 (video camera) illustrated in Fig. 64 includes a lens group 2001, a solid-state imaging device 2002 (the solid-state imaging device 1 according to the first embodiment), a digital signal processor (DSP) circuit 2003, a frame memory 2004, a monitor 2005, and a memory 2006. The DSP circuit 2003, the frame memory 2004, the monitor 2005, and the memory 2006 are connected to one another via a bus line 2007.

The lens group 2001 guides incident light (image light) from a subject to the solid-state imaging device 2002, and forms a light receiving surface (pixel region) of the solid-state imaging device 2002. The solid-state imaging device 2002 includes a CMOS image sensor according to the above-described first embodiment. The solid-state imaging device 2002 converts a light amount of the incident light formed on the light receiving surface by the lens group 2001 into an electrical signal in the pixel unit, and supplies the electrical signal as a pixel signal to the DSP circuit 2003. The DSP circuit 2003 performs predetermined image processing on the pixel signal supplied from the solid-state imaging device 2002. Furthermore, the DSP circuit 2003 supplies the image signal after image processing to the frame memory 2004 in the frame unit, and causes the frame memory 2004 to temporarily store the image signal. For example, the monitor 2005 is constituted of a panel type display device such as a liquid crystal panel or an organic Electro Luminescence (EL) panel. The monitor 2005 displays an image (moving image) of a subject on the basis of the pixel signal in the frame unit temporarily stored in the frame memory 2004. The memory 2006 is constituted of a DVD, a flash memory, or the like. The memory 2006 reads and stores the pixel signal in the frame unit temporarily stored in the frame memory 2004.

Note that the electronic device to which the solid-state imaging device 1 can be applied is not limited to the imaging devices 1000 and 2000 and can also be applied to other electronic devices. In addition, although there is employed a configuration where the solid-state imaging device 1 according to the first embodiment is used as the solid-state imaging device 1002 or 2002, other configurations can be also adopted. For example, configurations using other light detection devices to which the present technology is applied, such as the solid-state imaging devices 1 according to the second to fourth embodiments and the solid-state imaging device 1 according to the modification examples may be adopted.

The present technology can be also configured as follows.
(1) A light detection device including:
   a semiconductor substrate;
   a plurality of photoelectric conversion units that are formed in a two-dimensional array in the semiconductor substrate;
   a trench portion that is formed in a region between the photoelectric conversion units in the semiconductor substrate,
   a hole accumulation region that is formed on an inner wall surface of the trench portion, holes being accumulated in the hole accumulation region; and a light shielding film that is disposed on a side of a first surface that is a light receiving surface of the semiconductor substrate and shields light in a region between the photoelectric conversion units in an effective pixel region in the
   semiconductor substrate and a light shielding pixel region located around the effective pixel region as a whole,
   in which the hole accumulation region is continuously formed from the first surface to a second surface, which is a surface on a side opposite to the first surface, of the semiconductor substrate, and
   the light detection device further includes a connecting portion that is formed between the first surface in the light shielding pixel region and the light shielding film and causes the light shielding film to be electrically connected to the hole accumulation region.
(2) The light detection device according to (1) above, in which the hole accumulation region includes a p-type semiconductor region formed on the inner wall of the trench portion.
(3) The light detection device according to (1) or (2) above, including:
   a fixed charge film that has a negative charge covering the entire inner wall surface of the trench portion,
   in which the hole accumulation region includes a region formed by induction of holes by the fixed charge film.
(4) The light detection device according to any one of (1) to (3) above, in which in a view in a thickness direction of the semiconductor substrate, the connecting portion is disposed in a polygonal frame shape that surrounds a periphery of the effective pixel region and has an obtuse angle at each corner portion.
(5) The light detection device according to any one of (1) to (4) above, in which in a view in a thickness direction of the semiconductor substrate, at least a part of the connecting portion linearly extends such that the part overlaps a linearly extending part of the trench portion.
(6) The light detection device according to any one of (1) to (5) above, in which polysilicon is embedded inside of the trench portion.
(7) The light detection device according to any one of (1) to (6) above,
   in which two photoelectric conversion units with respect to one pixel are formed in the semiconductor substrate, and
   in a view in a thickness direction of the semiconductor substrate, a part of the trench portion located between the two photoelectric conversion units is separated on a center side of the pixel.
(8) The light detection device according to any one of (1) to (7), in which in a view in a thickness direction of the semiconductor substrate, the connecting portion is disposed in a divided manner like a dashed line such that the connecting portion surrounds a periphery of the effective pixel region.
(9) The light detection device according to any one of (1) to (8) above, in which in a view in a thickness direction of the semiconductor substrate, the connecting portion is disposed at each of positions in the light shielding pixel region facing vertexes at four corners of the effective pixel region.
(10) The light detection device according to any one of (1) to (9) above in which in a view in a thickness direction of the semiconductor substrate, the connecting portion is disposed at each of positions in the light shielding pixel region facing two mutually parallel sides of an outer edge of the effective pixel region.
(11) The light detection device according to any one of (1) to (9) above, in which in a view in a thickness direction of the semiconductor substrate, the connecting portion is disposed at each of positions in the light shielding pixel region facing sides of an outer edge of the effective pixel region and is divided by a part facing a vertex at each corner of the effective pixel region.
(12) The light detection device according to any one of (1) to (11) above, in which the trench portion is a penetrating trench portion that penetrates through the semiconductor substrate in a thickness direction of the semiconductor substrate.
(13) The light detection device according to any one of (1) to (11) above,
   in which the trench portion is a bottomed trench portion that includes an opening in the first surface of the semiconductor substrate and includes a bottom portion in the semiconductor substrate, and
   the hole accumulation region includes a p-type semiconductor region formed on the inner wall of the trench portion and a p-type semiconductor region formed on the side of the second surface of the semiconductor substrate.
(14) A light detection device including:
   a semiconductor substrate; and
   a plurality of photoelectric conversion units that are formed in a two-dimensional array in the semiconductor substrate;
   a trench portion that is formed in a region between the photoelectric conversion units in the semiconductor substrate,
   a conductor that is embedded in the trench portion; and
   a light shielding film that is disposed on a side of a first surface that is a light receiving surface of the semiconductor substrate and shields light in a region between the photoelectric conversion units in an effective pixel region in the semiconductor substrate and a light shielding pixel region located around the effective pixel region as a whole,
   in which the conductor is continuously formed from the first surface to a second surface, which is a surface on a side opposite to the first surface, of the semiconductor substrate, and
   the light detection device further includes a connecting portion that is formed between the first surface of the light shielding pixel region and the light shielding film and causes the light shielding film to be electrically connected to the conductor.
(15) The light detection device according to (14) above,
   in which a part that is formed in the effective pixel region and a part that is formed in the light shielding pixel region of the trench portion are physically disconnected by a peripheral edge portion of the effective pixel region, and a negative bias is applied to the conductor located at a part of the trench portion formed in the effective pixel region.
(16) The light detection device according to (14) above,
   in which a part in the trench portion formed in the effective pixel region and a part in the trench portion formed in the light shielding pixel region of the conductor are electrically disconnected by a peripheral edge portion of the effective pixel region, and
   a negative bias is applied to the conductor located at a part of the trench portion formed in the effective pixel region.
(17) A light detection device including:
   a semiconductor substrate; and
   a plurality of photoelectric conversion units that are formed in a two-dimensional array in the semiconductor substrate;
   a light shielding film that is disposed on a side of a first surface that is a light receiving surface of the semiconductor substrate and shields light in a region between the photoelectric conversion units in an effective pixel region in the semiconductor substrate and a peripheral region surrounding the effective pixel region;
   a hydrogen barrier film that is formed between the semiconductor substrate and the light shielding film and inhibits passage of hydrogen; and a connecting portion that is formed between the first surface of the peripheral region and the light shielding film, penetrates through the hydrogen barrier film, and causes the light shielding film to be electrically connected to a ground region of the semiconductor substrate, and
   in a view in a thickness direction of the semiconductor substrate, a range that the connecting portion occupies in a circumferential direction surrounding the effective pixel region is a part of an entire periphery in the circumferential direction.
(18) The light detection device according to (17) above, in which in a view in the thickness direction of the semiconductor substrate, the connecting portion is disposed in a divided manner like a dashed line such that the connecting portion surrounds a periphery of the effective pixel region.
(19) The light detection device according to (17) above, in which in a view in the thickness direction of the semiconductor substrate, the connecting portion is disposed in a divided manner like a dashed line at each of positions in the peripheral region facing two mutually parallel sides of an outer edge of the effective pixel region.
(20) The light detection device according to (17) above, in which in a view in the thickness direction of the semiconductor substrate, the connecting portion is disposed at each of positions in the peripheral region surrounding four corners of the effective pixel region, and parts following two sides sandwiching a vertex at each corner are divided at a part corresponding to the vertex.
(21) The light detection device according to (20) above, in which in a view in the thickness direction of the semiconductor substrate, the connecting portion is disposed at each of positions in the peripheral region facing vertexes at four corners of the effective pixel region, and a longitudinal direction of parts facing the vertexes is inclined with respect to each of two mutually perpendicularly intersecting directions of an outer edge of the effective pixel region.
(22) The light detection device according to any one of (17) to (21) above, in which a material of the light shielding film is tungsten, aluminum, or copper.
(23) The light detection device according to (1) above, further including:
   a protective film that is formed between the semiconductor substrate and the light shielding film and covers the first surface of the semiconductor substrate,
   in which the connecting portion is formed between the first surface of the light shielding pixel region and the light shielding film and penetrates through the protective film such that the light shielding film and the hole accumulation region are electrically connected to each other, and
   in a view in a thickness direction of the semiconductor substrate, the connecting portion is disposed by being divided into a plurality of divided pieces to avoid a region on the first surface where the trench portion is formed.
(24) The light detection device according to (23) above, in which the connecting portion is divided such that each of the divided pieces is disposed for one pixel.
(25) The light detection device according to (24) above, in which in a view in the thickness direction of the semiconductor substrate, an outer shape of the divided pieces is a rectangular shape.
(26) The light detection device according to (24) above, in which in a view in the thickness direction of the semiconductor substrate, an outer shape of the divided pieces is a polygonal shape with a contour following a shape of the inner wall surface of the trench portion.
(27) The light detection device according to (23) to (26) above,
   a p-type semiconductor region that is formed on the first surface of the semiconductor substrate and is electrically connected to the hole accumulation region,
   in which the connecting portion is in contact with the p-type semiconductor region and is electrically connected to the hole accumulation region via the p-type semiconductor region.
(28) The light detection device according to (23) above, in which the connecting portion is divided such that two or more of the divided pieces are disposed for one pixel.
(29) The light detection device according to (23) to (28) above, in which in a view in the thickness direction of the semiconductor substrate, the connecting portion is also disposed by being divided into a plurality of divided pieces to avoid a part of a region of the first surface where the trench portion is not formed as well as the region thereof where the trench portion is formed.
(30) The light detection device according to any one of (23) to (29) above, in which the trench portion is a trench portion that is formed to penetrate through the semiconductor substrate from the first surface to the second surface or a trench portion that is formed from the first surface to a midway position between the first surface and the second surface.
(31) An electronic device including:
   a light detection device that includes a semiconductor substrate, a plurality of photoelectric conversion units that are formed in a two-dimensional array in the semiconductor substrate, a trench portion that is formed in a region between the photoelectric conversion units in the semiconductor substrate, a hole accumulation region that is formed on an inner wall surface of the trench portion,
   holes being accumulated in the hole accumulation region, and a light shielding film that is disposed on a side of a first surface that is a light receiving surface of the semiconductor substrate and shields light in a region between the photoelectric conversion units in an effective pixel region in the semiconductor substrate and a light shielding pixel region located around the effective pixel region as a whole, in which the hole accumulation region is continuously formed from the first surface to a second surface, which is a surface on a side opposite to the first surface, of the semiconductor substrate, and the light detection device further includes a connecting portion that is formed between the first surface of the light shielding pixel region and the light shielding film and causes the light shielding film to be electrically connected to the hole accumulation region.
(32) An electronic device including:
   a light detection device that includes a semiconductor substrate, a plurality of photoelectric conversion units that are formed in a two-dimensional array in the semiconductor substrate, a trench portion that is formed in a region between the photoelectric conversion units in the semiconductor substrate, a conductor that is embedded in the trench portion, and a light shielding film that is disposed on a side of a first surface that is a light receiving surface of the semiconductor substrate and shields light in a region between the photoelectric conversion units in an effective pixel region in the semiconductor substrate and a light shielding pixel region located around the effective pixel region as a whole, in which the conductor is continuously formed from the first surface to a second surface, which is a surface on a side opposite to the first surface, of the semiconductor substrate, and the light detection device further includes a connecting portion that is formed between the first surface of the light shielding pixel region and the light shielding film and causes the light shielding film to be electrically connected to the conductor.
(33) An electronic device including:
   a light detection device that includes a semiconductor substrate, a plurality of photoelectric conversion units that are formed in a two-dimensional array in the semiconductor substrate, a light shielding film that is disposed on a side of a first surface that is a light receiving surface of the semiconductor substrate and
   shields light in a region between the photoelectric conversion units in an effective pixel region in the semiconductor substrate and a peripheral region surrounding the effective pixel region, a hydrogen barrier film that is formed between the semiconductor substrate and the light shielding film and inhibits passage of hydrogen, and a connecting portion that is formed between the first surface of the peripheral region and the light shielding film, penetrates through the hydrogen barrier film, and causes the light shielding film to be electrically connected to a ground region of the semiconductor substrate, in which in a view in a thickness direction of the semiconductor substrate, a range that the connecting portion occupies in a circumferential direction surrounding the effective pixel region is a part of an entire periphery in the circumferential direction.

### [Reference Signs List]

1 Solid-state imaging device
2 Pixel region
3 Vertical drive circuit
4 Column signal processing circuit
5 Horizontal drive circuit
6 Output circuit
7 Control circuit
8 Pixel
9 Pixel drive wiring
10 Vertical signal line
11 Horizontal signal line
12 Semiconductor substrate
13 Insulating film
14 Light shielding film
18 Wiring layer
19 First conductivity-type region
20 Second conductivity-type region
21 Contact
22 Trench portion
23 Hole accumulation region
24 Contact
24a Divided contact
25 Barrier metal layer
26 Wiring
27 p-well region
28 Inner wall surface-side part
29 Trench portion
30 Polysilicon
31 Gate
32 Contact
33 Logic substrate
34 Groove
35 Fixed charge film
36 p-type layer
37 Conductor
37a First conductor
37b Second conductor
38 Disconnected region
39 Connecting portion
40 Penetrating electrode
41 Connecting portion
42 Penetrating electrode
43 Region
44 Hydrogen barrier film
45 Through-hole
46 Ground region
47 Contact
48 Silicon oxide film
49 Oxide film
50 Hydrogen
60 Effective pixel region
70 Peripheral region
71 Light shielding pixel region
72 Outer region
73 Connecting portion
73a Divided piece
74 Through-hole
75 Mask
76 On-chip lens
77 Semiconductor region

## Claims

1. A light detection device comprising:
a semiconductor substrate;
a plurality of photoelectric conversion units that are formed in a two-dimensional array in the semiconductor substrate;
a trench portion that is formed in a region between the photoelectric conversion units in the semiconductor substrate,
a hole accumulation region that is formed on an inner wall surface of the trench portion, holes being accumulated in the hole accumulation region; and
a light shielding film that is disposed on a side of a first surface that is a light receiving surface of the semiconductor substrate and shields light in a region between the photoelectric conversion units in an effective pixel region in the semiconductor substrate and a light shielding pixel region located around the effective pixel region as a whole,
wherein the hole accumulation region is continuously formed from the first surface to a second surface, which is a surface on a side opposite to the first surface, of the semiconductor substrate, and
the light detection device further includes a connecting portion that is formed between the first surface in the light shielding pixel region and the light shielding film and causes the light shielding film to be electrically connected to the hole accumulation region.

2. The light detection device according to claim 1, wherein the hole accumulation region includes a p-type semiconductor region formed on the inner wall of the trench portion.

3. The light detection device according to claim 1, comprising:
a fixed charge film that has a negative charge covering the entire inner wall surface of the trench portion,
wherein the hole accumulation region includes a region formed by induction of holes by the fixed charge film.

4. The light detection device according to claim 1, wherein in a view in a thickness direction of the semiconductor substrate, the connecting portion is disposed in a polygonal frame shape that surrounds a periphery of the effective pixel region and has an obtuse angle at each corner portion.

5. The light detection device according to claim 1, wherein in a view in a thickness direction of the semiconductor substrate, at least a part of the connecting portion linearly extends such that the part overlaps a linearly extending part of the trench portion.

6. The light detection device according to claim 1, wherein polysilicon is embedded inside of the trench portion.

7. The light detection device according to claim 1,
wherein two photoelectric conversion units with respect to one pixel are formed in the semiconductor substrate, and
in a view in a thickness direction of the semiconductor substrate, a part of the trench portion located between the two photoelectric conversion units is separated on a center side of the pixel.

8. The light detection device according to claim 1, wherein in a view in a thickness direction of the semiconductor substrate, the connecting portion is disposed in a divided manner like a dashed line such that the connecting portion surrounds a periphery of the effective pixel region.

9. The light detection device according to claim 1, wherein in a view in a thickness direction of the semiconductor substrate, the connecting portion is disposed at each of positions in the light shielding pixel region facing vertexes at four corners of the effective pixel region.

10. The light detection device according to claim 1, wherein in a view in a thickness direction of the semiconductor substrate, the connecting portion is disposed at each of positions in the light shielding pixel region facing two mutually parallel sides of an outer edge of the effective pixel region.

11. The light detection device according to claim 1, wherein in a view in a thickness direction of the semiconductor substrate, the connecting portion is disposed at each of positions in the light shielding pixel region facing sides of an outer edge of the effective pixel region and is divided by a part facing a vertex at each corner of the effective pixel region.

12. The light detection device according to claim 1, wherein the trench portion is a penetrating trench portion that penetrates through the semiconductor substrate in a thickness direction of the semiconductor substrate.

13. The light detection device according to claim 1,
wherein the trench portion is a bottomed trench portion that includes an opening in the first surface of the semiconductor substrate and includes a bottom portion in the semiconductor substrate, and
the hole accumulation region includes a p-type semiconductor region formed on the inner wall of the trench portion and a p-type semiconductor region formed on the side of the second surface of the semiconductor substrate.

14. An light detection device comprising:
a semiconductor substrate;
a plurality of photoelectric conversion units that are formed in a two-dimensional array in the semiconductor substrate;
a trench portion that is formed in a region between the photoelectric conversion units in the semiconductor substrate,
a conductor that is embedded in the trench portion; and
a light shielding film that is disposed on a side of a first surface that is a light receiving surface of the semiconductor substrate and shields light in a region between the photoelectric conversion units in an effective pixel region in the semiconductor substrate and a light shielding pixel region located around the effective pixel region as a whole,
wherein the conductor is continuously formed from the first surface to a second surface, which is a surface on a side opposite to the first surface, of the semiconductor substrate, and
the light detection device further includes a connecting portion that is formed between the first surface of the light shielding pixel region and the light shielding film and causes the light shielding film to be electrically connected to the conductor.

15. The light detection device according to claim 14,
wherein a part that is formed in the effective pixel region and a part that is formed in the light shielding pixel region of the trench portion are physically disconnected by a peripheral edge portion of the effective pixel region, and
a negative bias is applied to the conductor located at a part of the trench portion formed in the effective pixel region.

16. The light detection device according to claim 14,
wherein a part in the trench portion formed in the effective pixel region and a part in the trench portion formed in the light shielding pixel region of the conductor are electrically disconnected by a peripheral edge portion of the effective pixel region, and
a negative bias is applied to the conductor located at a part of the trench portion formed in the effective pixel region.

17. A light detection device comprising:
a semiconductor substrate;
a plurality of photoelectric conversion units that are formed in a two-dimensional array in the semiconductor substrate;
a light shielding film that is disposed on a side of a first surface that is a light receiving surface of the semiconductor substrate and shields light in a region between the photoelectric conversion units in an effective pixel region in the semiconductor substrate and a peripheral region surrounding the effective pixel region;
a hydrogen barrier film that is formed between the semiconductor substrate and
the light shielding film and inhibits passage of hydrogen; and
a connecting portion that is formed between the first surface of the peripheral region and the light shielding film, penetrates through the hydrogen barrier film, and causes the light shielding film to be electrically connected to a ground region of the semiconductor substrate, and
in a view in a thickness direction of the semiconductor substrate, a range that the connecting portion occupies in a circumferential direction surrounding the effective pixel region is a part of an entire periphery in the circumferential direction.

18. The light detection device according to claim 17, wherein in a view in the thickness direction of the semiconductor substrate, the connecting portion is disposed in a divided manner like a dashed line such that the connecting portion surrounds a periphery of the effective pixel region.

19. The light detection device according to claim 17, wherein in a view in the thickness direction of the semiconductor substrate, the connecting portion is disposed in a divided manner like a dashed line at each of positions in the peripheral region facing two mutually parallel sides of an outer edge of the effective pixel region.

20. The light detection device according to claim 17, wherein in a view in the thickness direction of the semiconductor substrate, the connecting portion is disposed at each of positions in the peripheral region surrounding four corners of the effective pixel region, and parts following two sides sandwiching a vertex at each corner are divided at a part corresponding to the vertex.

21. The light detection device according to claim 20, wherein in a view in the thickness direction of the semiconductor substrate, the connecting portion is disposed at each of positions in the peripheral region facing vertexes at four corners of the effective pixel region, and a longitudinal direction of parts facing the vertexes is inclined with respect to each of two mutually perpendicularly intersecting directions of an outer edge of the effective pixel region.

22. The light detection device according to claim 17, wherein a material of the light shielding film is tungsten, aluminum, or copper.

23. The light detection device according to claim 1, further including:
a protective film that is formed between the semiconductor substrate and the light shielding film and covers the first surface of the semiconductor substrate,
wherein the connecting portion is formed between the first surface of the light shielding pixel region and the light shielding film and penetrates through the protective film such that the light shielding film and the hole accumulation region are electrically connected to each other, and
in a view in a thickness direction of the semiconductor substrate, the connecting portion is disposed by being divided into a plurality of divided pieces to avoid a region on the first surface where the trench portion is formed.

24. The light detection device according to claim 23, wherein the connecting portion is divided such that each of the divided pieces is disposed for one pixel.

25. The light detection device according to claim 24, wherein in a view in the thickness direction of the semiconductor substrate, an outer shape of the divided pieces is a rectangular shape.

26. The light detection device according to claim 24, wherein in a view in the thickness direction of the semiconductor substrate, an outer shape of the divided pieces is a polygonal shape with a contour following a shape of the inner wall surface of the trench portion.

27. The light detection device according to claim 23,
a p-type semiconductor region that is formed on the first surface of the semiconductor substrate and is electrically connected to the hole accumulation region,
wherein the connecting portion is in contact with the p-type semiconductor region and is electrically connected to the hole accumulation region via the p-type semiconductor region.

28. The light detection device according to claim 23, wherein the connecting portion is divided such that two or more of the divided pieces are disposed for one pixel.

29. The light detection device according to claim 23, wherein in a view in the thickness direction of the semiconductor substrate, the connecting portion is also disposed by being divided into a plurality of divided pieces to avoid a part of a region of the first surface where the trench portion is not formed as well as the region thereof where the trench portion is formed.

30. The light detection device according to claim 23, wherein the trench portion is a trench portion that is formed to penetrate through the semiconductor substrate from the first surface to the second surface or a trench portion that is formed from the first surface to a midway position between the first surface and the second surface.

31. An electronic device comprising:
a light detection device that includes a semiconductor substrate, a plurality of photoelectric conversion units that are formed in a two-dimensional array in the semiconductor substrate, a trench portion that is formed in a region between the photoelectric conversion units in the semiconductor substrate, a hole accumulation region that is formed on an inner wall surface of the trench portion,
holes being accumulated in the hole accumulation region, and a light shielding film that is disposed on a side of a first surface that is a light receiving surface of the semiconductor substrate and shields light in a region between the photoelectric conversion units in an effective pixel region in the semiconductor substrate and a light shielding pixel region located around the effective pixel region as a whole, in which the hole accumulation region is continuously formed from the first surface to a second surface, which is a surface on a side opposite to the first surface, of the semiconductor substrate, and the light detection device further includes a connecting portion that is formed between the first surface of the light shielding pixel region and the light shielding film and causes the light shielding film to be electrically connected to the hole accumulation region.

32. An electronic device comprising:
a light detection device that includes a semiconductor substrate, a plurality of photoelectric conversion units that are formed in a two-dimensional array in the semiconductor substrate, a trench portion that is formed in a region between the photoelectric conversion units in the semiconductor substrate, a conductor that is embedded in the trench portion, and a light shielding film that is disposed on a side of a first surface that is a light receiving surface of the semiconductor substrate and shields light in a region between the photoelectric conversion units in an effective pixel region in the semiconductor substrate and a light shielding pixel region located around the effective pixel region as a whole, in which the conductor is continuously formed from the first surface to a second surface, which is a surface on a side opposite to the first surface, of the semiconductor substrate,
and the light detection device further includes a connecting portion that is formed between the first surface of the light shielding pixel region and the light shielding film and causes the light shielding film to be electrically connected to the conductor.

33. An electronic device comprising:
a light detection device that includes a semiconductor substrate, a plurality of photoelectric conversion units that are formed in a two-dimensional array in the semiconductor substrate, a light shielding film that is disposed on a side of a first surface that is a light receiving surface of the semiconductor substrate and shields light in a region between the photoelectric conversion units in an effective pixel region in the semiconductor substrate and a peripheral region surrounding the effective pixel region, a hydrogen barrier film that is formed between the semiconductor substrate and the light shielding film and inhibits passage of hydrogen, and a connecting portion that is formed between the first surface of the peripheral region and the light shielding film, penetrates through the hydrogen barrier film, and causes the light shielding film to be electrically connected to a ground region of the semiconductor substrate, in which in a view in a thickness direction of the semiconductor substrate, a range that the connecting portion occupies in a circumferential direction surrounding the effective pixel region is a part of an entire periphery in the circumferential direction.
